(19) Europäisches Patentamt
European Patent Office
Office européen des brevets

(11) **EP 4 343 196 A1**

(12) **EUROPÄISCHE PATENTANMELDUNG**

(43) Veröffentlichungstag:
**27.03.2024   Patentblatt 2024/13**

(21) Anmeldenummer: 23194761.5

(22) Anmeldetag: **01.09.2023**

(51) Internationale Patentklassifikation (IPC):
***F17C 3/08*** *(2006.01)*

(52) Gemeinsame Patentklassifikation (CPC):
**F17C 3/085;** F17C 2201/0185; F17C 2201/019;
F17C 2201/0195; F17C 2201/058;
F17C 2203/0391; F17C 2205/0355;
F17C 2205/0358; F17C 2205/0364;
F17C 2221/017; F17C 2223/0161; F17C 2223/033;
F17C 2227/0107; F17C 2227/0135;
F17C 2227/0157;                    (Forts.)

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **21.09.2022   DE 102022209941**

(71) Anmelder: **Bruker Switzerland AG
8117 Fällanden (CH)**

(72) Erfinder: **Wikus, Patrick
8309 Nürensdorf (CH)**

(74) Vertreter: **Kohler Schmid Möbus Patentanwälte
Partnerschaftsgesellschaft mbB
Gropiusplatz 10
70563 Stuttgart (DE)**

(54) **VORRICHTUNG ZUM TRANSFER VON FLÜSSIGEM HELIUM, MIT VERRINGERTEN TRANSFER-VERLUSTEN**

(57)    Eine Vorrichtung (5) zum Transfer von flüssigem Helium (6) in einen Nutz-Heliumbehälter (3) eines Nutz-Kryostaten (2), wobei die Vorrichtung (5) umfasst:
- einen Reservoir-Kryostaten (7) mit einem vakuumisolierten Reservoir-Heliumbehälter (8), zur Bevorratung von flüssigem Helium (6, 6b), das zum Befüllen des Nutz-Heliumbehälters (3) zur Verfügung steht,
- eine Zuführleitung (9) für flüssiges Helium (6, 6c), die vom Reservoir-Heliumbehälter (8) abgeht, zum Anschluss an den Nutz-Heliumbehälter (3);
ist dadurch gekennzeichnet,
dass die Vorrichtung (5) weiterhin umfasst:

- eine Rückführleitung (10) für gasförmiges Helium (11, 11c), die in den Reservoir-Heliumbehälter (8) führt, zum Anschluss an den Nutz-Heliumbehälter (3), und
- eine Fördereinrichtung (49), mit der flüssiges Helium (6, 6b) aus dem Reservoir-Heliumbehälter (8) durch die Zuführleitung (9) in den Nutz-Heliumbehälter (3) und gasförmiges Helium (11, 11a) aus dem Nutz-Heliumbehälter (3) durch die Rückführleitung (10) in den Reservoir-Heliumbehälter (8) förderbar ist. Die Erfindung stellt eine Vorrichtung zum Transfer von flüssigem Helium zur Verfügung, mit der auf einfache Weise Transferverluste verringert werden können.

Fig. 1

**EP 4 343 196 A1**

(52) Gemeinsame Patentklassifikation (CPC): (Forts.)
F17C 2227/0353; F17C 2250/032;
F17C 2250/043; F17C 2265/032; F17C 2265/034;
F17C 2270/0509; F17C 2270/0536

**Beschreibung**

Die Erfindung betrifft eine Vorrichtung zum Transfer von flüssigem Helium in einen Nutz-Heliumbehälter eines Nutz-Kryostaten, wobei die Vorrichtung umfasst:

- einen Reservoir-Kryostaten mit einem vakuumisolierten Reservoir-Heliumbehälter, zur Bevorratung von flüssigem Helium, das zum Befüllen des Nutz-Heliumbehälters zur Verfügung steht,
- eine Zuführleitung für flüssiges Helium, die vom Reservoir-Heliumbehälter abgeht, zum Anschluss an den Nutz-Heliumbehälter.

Eine solche Vorrichtung zum Transfer ist beispielsweise bekannt geworden durch die Firmendruckschrift "NMR Magnet System UltraShield Magnets (English version) User Manual Version 006" der Bruker Bio-Spin AG, Fällanden, Schweiz, datiert 12.10.2004, insbesondere dortiges Kapitel 12 (Seiten 26-30).

Flüssiges Helium wird zum Kühlen verschiedener Anwendungen benötigt, beispielsweise zum Kühlen von supraleitenden Magneten von NMR-Spektrometern (NMR= nuclear magentic resonance, Kernspinresonanz) und MRI-Systemen (MRI=magnetic resonance imaging, bildgebende Magnetresonanz). Dabei ist in einem Nutz-Kryostaten ein vakuumisolierter Nutz-Heliumbehälter ausgebildet, in welchem flüssiges Helium gespeichert ist. Mit dem flüssigen Helium wird ein Objekt gekühlt, beispielsweise eine Magnetspule, die im flüssigen Helium angeordnet ist.

Das flüssige Helium wird bei der Kühlung der Anwendung langsam verbraucht, so dass typischerweise nach einigen Monaten flüssiges Helium in den Nutz-Kryostaten nachgefüllt werden muss. Flüssiges Helium ist ein knappes und vergleichsweise teures Gut.

Das übliche Vorgehen zum Nachfüllen von flüssigem Helium erfolgt meist wie folgt, vgl. die Firmendruckschrift "NMR Magnet System UltraShield Magnets..." der Bruker BioSpin AG oben:

1) Ein Reservoir-Kryostat (auch genannt Transportdewar) mit einem vakuumisolierten Reservoir-Heliumbehälter, in welchem flüssiges Helium zum Nachfüllen des Nutz-Kryostaten bevorratet ist, wird in die Nähe des NutzKryostaten gebracht.

2) Eine raumtemperaturwarme Zuführleitung (auch Transferleitung genannt) wird mit einem Ende in den Reservoir-Kryostaten eingeführt, bis das Ende der Zuführleitung in das flüssige Helium ragt.

3) Dadurch wird das Helium im Reservoir-Kryostaten etwas erwärmt, und der Heliumgasdruck steigt im Reservoir-Kryostaten und drückt flüssiges Helium in die Zuführleitung, das zunächst als gasförmiges Helium am anderen Ende der Zuführleitung in die Umgebung ausströmt. Die Zuführleitung kühlt allmählich ab, und schließlich entweicht flüssiges Helium aus dem anderen Ende der Zuführleitung.

4) Sodann wird das andere Ende der Zuführleitung in den Nutz-Kryostaten eingeführt.

5) Sodann fließt flüssiges Helium in den Nutz-Kryostaten, und gleichzeitig wird gasförmiges Helium aus dem Nutz-Kryostaten herausgedrückt, der näherungsweise auf Atmosphärendruck bleibt. Das herausgedrückte gasförmige Helium entweicht meist in die Umgebung, oder der Nutz-Kryostat ist mit einem Rückgewinnungssystem verbunden, das das gasförmige Helium auffängt.

6) Um im Reservoir-Kryostaten einen ausreichenden Druck für das Fördern des flüssigen Heliums in den Nutz-Kryostaten sicherzustellen, wird der Reservoir-Kryostat an eine Helium-Druckgasflache angeschlossen, und der Überdruck im Reservoir-Kryostaten wird auf ca. 50-100 mbar eingestellt, was für den Heliumtransfer ausreicht.

Dieser Prozess ist mit vergleichsweise einfacher Ausrüstung gut umsetzbar. Jedoch geht bei diesem Prozess vergleichsweise viel Helium in die Umgebung verloren, sowohl beim Abkühlen der Zuführleitung, als auch beim eigentlichen Befüllen des Nutz-Kryostaten mit flüssigem Helium. Zudem ist das Einleiten von raumtemperaturwarmem Helium aus einer Helium-Druckgasflasche in den Reservoir-Kryostaten, um damit flüssiges Helium aus dem Reservoir-Kryostaten auszufördern, energetisch ungünstig.

Rückgewinnungssysteme, die das aus dem Nutz-Kryostaten austretende gasförmige Helium beim Befüllen des Nutz-Kryostaten mit flüssigem Helium auffangen könnten, sind vergleichsweise aufwändig und teuer. Das kalte Helium, das während des Transfers aus dem Nutz-Kryostaten entweicht, wärmt sich am Weg zum Rückgewinnungssystem auf Raumtemperatur auf, und erfährt deshalb eine signifikante Volumenzunahme um einen Faktor 10 und mehr. Das Helium, das aus dem Nutz-Kryostaten entweicht, muss in vielen Fällen sogar aktiv erwärmt werden, da Komponenten des Rückgewinnungssystems (Kompressoren, Ballonspeicher, usw.) nicht wirtschaftlich für den Betrieb mit kalten Gasen ausgelegt werden können.

Rückgewinnungssysteme verfügen typischerweise entweder über einen großen Niederdruckspeicher zum Zwischenspeichern des gasförmiges Heliums vor dessen Verflüssigung oder Kompression zur platzsparenden Lagerung (etwa einen großvolumigen Ballonspeicher, der vergleichsweise viel Platz benötigt) oder einen Hochdruckspeicher mit vorgeschaltetem, sehr leistungsstarkem und damit teurem Kompressor, der für den Heliumstrom, der beim Nachfüllen des flüssigen Heliums in den Nutz-Kryostaten aus dem Nutz-Kryostaten herausgedrückt wird, unmittelbar ausgelegt sein muss. Das aus dem Nutz-Kryostaten entweichende Helium könnte theoretisch auch durch eine entsprechend dimensioniere Kältemaschine zur platzsparenden Lagerung im flüssigen Zustand direkt abgekühlt und verflüssigt werden. Die Kältemaschine des Rückgewinnungssystems müsste dann aber für den sehr hohen Heliumgasstrom, der beim Nachfüllen des flüssigen Heliums in den Nutz-Kryostaten aus dem Nutz-Kryostaten herausgedrückt wird, unmittelbar ausgelegt sein. In letzterem Fall wäre die Kältemaschine sehr teuer, und würde während des Normalbetriebs der Anwendung nicht annähernd ausgelastet.

Die US 2011 0 312 502 A schlägt vor, den Transfer von flüssigem Helium aus einem Container zu einem Magneten über den Gasdruck im Container zu steuern.

In der US 2019/0 211 970 A1 wird ein System zum automatischen Nachfüllen von kryogenem Helium beschrieben. Das System umfasst eine automatische Ventileinrichtung, mit der Heliumgas aus einer Druckgasquelle in einen LHe-Dewar eingeleitet werden kann, der über eine Transferleitung für flüssiges Helium mit einem LHe-Kryostaten verbunden ist. Die Füllstände an LHe im LHe-Dewar und im LHe-Kryostaten sind sensorüberwacht.

Die US 3 399 691 schlägt vor, flüssiges Helium von einem Vorratsort zu einem Behälter mit einer kalten Pumpe zu pumpen.

In der JP S54 161 109 A wird vorgeschlagen, in der Zuführungsleitung zwischen einem Vorratscontainer für flüssiges Helium und einem Kryostaten ein Auslassventil vorzusehen, und zur Vorbereitung eines Transfers von flüssigem Helium zunächst einen vorderen Teil der Zuführleitung zu kühlen, wobei gasförmiges Helium durch das Auslassventil in einem Ballonspeicher aufgefangen wird.

Die FR 2 752 037 A1 sieht vor, beim Befüllen eines Kryostaten mit flüssigem Helium aus dem Kryostaten ausströmendes gasförmiges Helium an der Zuführleitung für das flüssige Helium vorbeizuführen. Das ausströmende Helium wird aufgefangen und kann insbesondere komprimiert werden.

Aus J.G. Weisend II (Hrsg.), Cryostat Design, International Cryogenics Monograph Series, Springer International Publishing Switzerland 2016, Kapitel 9, sind verschiedene Arten von kryogenen Transferleitungen, insbesondere mit Vakuumisolation, bekannt geworden.

Die US 6 442 948 B1 beschreibt eine Rekondensations-Einrichtung für flüssiges Helium, wobei aus einem Reservoir für flüssiges Helium gasförmiges Helium über eine Leitung zu einem Refrigerator geführt wird, am Refrigerator verflüssigt wird, und das rückverflüssigte Helium über eine weitere Leitung in das Reservoir zurückgeführt wird. Die Leitung und die weitere Leitung verlaufen in einer gemeinsamen Vakuumisolation.

Aus der Firmendruckschrift "Heliosmart Recovery Technical Specifications" der der Firma Bruker BioSpin, datiert 03/2022, ist es bekannt, aus einem NMR-Magneten im Dauerbetrieb abdampfendes Helium aufzufangen und in Druckgaszylindern zu speichern. Das Bruker Heliosmart Recovery verfügt über einen internen Ballonspeicher und einen dreistufigen Hochdruckkompressor. Es ist nicht dafür ausgelegt, Helium aufzufangen und zu speichern, das bei den hohen Flussraten anfällt, die beim Nachfüllen von flüssigem Helium in einen Nutz-Kryostaten aus diesem Nutz-Kryostaten herausgedrückt wird.

In D. Kramer, "Helium is again short in supply", Physics Today, 4. April 2022, wird ein aktueller Engpass in der Versorgung mit flüssigem Helium beschrieben, der zu einer Verdoppelung des Preises für Helium in den letzten zwei Jahren geführt hat.

Aufgabe der Erfindung

Es ist Aufgabe der Erfindung, eine Vorrichtung zum Transfer von flüssigem Helium zur Verfügung zu stellen, mit der auf einfache Weise Transferverluste verringert werden können.

Beschreibung der Erfindung

Diese Aufgabe wird erfindungsgemäß gelöst durch eine Vorrichtung der eingangs genannten Art, die dadurch gekennzeichnet ist,
dass die Vorrichtung weiterhin umfasst:

- eine Rückführleitung für gasförmiges Helium, die in den Reservoir-Heliumbehälter führt, zum Anschluss an den Nutz-Heliumbehälter, und

- eine Fördereinrichtung, mit der flüssiges Helium aus dem Reservoir-Heliumbehälter durch die Zuführleitung in den Nutz-Heliumbehälter und gasförmiges Helium aus dem Nutz-Heliumbehälter durch die Rückführleitung in den Reservoir-Heliumbehälter förderbar ist.

Im Rahmen der Erfindung kann mittels der Zuführleitung und der Rückführleitung ein geschlossenes System bei der Befüllung des Nutz-Kryostaten oder dessen Nutz-Heliumbehälters mit flüssigem Helium aus dem Reservoir-Kryostaten oder dessen Reservoir-Heliumbehälters eingerichtet werden.

Gasförmiges Helium, das beim Befüllen des Nutz-Heliumbehälters mit neuem flüssigem Helium aus diesem herausgedrückt wird, wird ohne Zwischenspeicherung und mit geringem Wärmeeintrag über die Rückführleitung zurück in den Reservoir-Heliumbehälter verbracht, und geht entsprechend nicht verloren. Eine aufwändige Zwischenspeicherung des gasförmigen Heliums vor dessen Komprimierung oder Verflüssigung (etwa in einem Ballonspeicher bei Atmosphärendruck und Umgebungstemperatur) ist im Rahmen der Erfindung nicht nötig und auch nicht vorgesehen. Das solchermaßen in den Reservoir-Heliumbehälter eingeleitete gasförmige Helium kann dazu beitragen, das flüssige Helium aus dem Reservoir-Heliumbehälter in die Zuführleitung herauszufördern, insbesondere herauszudrücken.

Falls keine merklichen Wärmeeinträge stattfinden, entspricht das Volumen des aus dem Nutz-Heliumtank herausgedrückten gasförmigen Heliums dem Volumen des aus dem Reservoir-Heliumtank ausgeförderten flüssigen Heliums und auch dem Volumen des in den Reservoir-Heliumbehälter zurückgeführten gasförmigen Heliums. In der Praxis wird sich eine gewisse Erwärmung nicht vermeiden lassen, so dass zumindest zeitweilig ein wenig mehr (bezogen auf das Volumen) gasförmiges Helium in den Reservoir-Heliumbehälter eingefördert wird als an flüssigem Helium aus dem Reservoir-Heliumbehälter ausgefördert wird, unter entsprechendem Anstieg des Drucks im Reservoir-Heliumbehälter. Dies kann bei der Ausförderung des flüssigen Heliums durch die Zuführleitung nützlich sein, und ist (wenn der Druckanstieg nicht zu groß wird) unkritisch. Falls das flüssige Helium im Reservoir-Heliumbehälter eine Temperatur etwas unter dem Siedepunkt (4,2 K bei Atmosphärendruck) aufweist, kann das in den Reservoir-Heliumbehälter eingeförderte gasförmige Helium durch das flüssige Helium wieder abgekühlt werden, insbesondere bis auf 4,2 K, wodurch ein Druckanstieg im Reservoir-Heliumbehälter begrenzt bleibt. Beispielsweise kann (zu Beginn des Transfers von flüssigem Helium) die Temperatur des flüssigen Heliums im Reservoir-Heliumbehälter 3,6 K oder weniger oder 3,0 K oder weniger betragen. Im Falle eines übermäßigen Druckanstiegs kann auch ausnahmsweise gasförmiges Helium aus dem System, etwa aus dem Reservoir-Heliumbehälter, abgelassen werden, insbesondere über ein Sicherheitsventil (Überdruckventil) in die Umgebung. In der Regel ist dies aber nicht notwendig, und bevorzugt ist die Kryostaten-Anordnung umfassend die Vorrichtung zum Transfer und den angeschlossenen Nutz-Kryostaten beim Transfer des flüssigen Heliums geschlossen für das Helium eingerichtet.

Mit der Fördereinrichtung wird das flüssige Helium aus dem Reservoir-Heliumbehälter in den Nutz-Heliumbehälter gefördert, und gasförmiges Helium aus dem Nutz-Heliumbehälter in den Reservoir-Heliumbehälter gefördert. Typischerweise erfolgt dabei die Förderung des einen Stroms direkt (meist der Strom des gasförmigen Heliums) und die Förderung des anderen Gasstroms indirekt (meist der Strom des flüssigen Heliums). Die Fördereinrichtung umfasst typischerweise eine fördernde Pumpe. Über die Fördereinrichtung kann auf den Druck (Gasdruck) im Reservoir-Heliumbehälter und im Nutz-Heliumbehälter Einfluss genommen werden, und insbesondere auf eine Druckdifferenz zwischen Reservoir-Heliumbehälter und Nutz-Heliumbehälter. In der Regel ist während des Transfers der Druck im Reservoir-Heliumbehälter etwas größer als der Druck im Nutz-Heliumbehälter. Typischerweise wird im gesamten System ein leichter Überdruck gegenüber dem Atmosphärendruck in der Umgebung aufrechterhalten, um eine Verunreinigung des Heliumkreislaufs mit Luft oder Luftbestandteilen zu minimieren.

Der Reservoir-Heliumbehälter und der Nutz-Heliumbehälter haben typischerweise jeweils ein Speichervolumen von wenigstens 50 Litern, bevorzugt wenigstens 100 Litern.

*Bevorzugte Ausführungsformen der Erfindung*

Bei einer bevorzugten Ausführungsform der erfindungsgemäßen Vorrichtung sind die Zuführleitung und die Rückführleitung vakuumisoliert. Dadurch wird eine Erwärmung des flüssigen Heliums und des gasförmigen Heliums beim Transport zwischen den Heliumbehältern minimiert.

Bevorzugt ist eine Weiterbildung dieser Ausführungsform, bei der die Zuführleitung und die Rückführleitung zumindest teilweise in einer gemeinsamen Transportleitung ausgebildet sind, die innerhalb einer gemeinsamen Vakuumbegrenzung einen Vakuumraum aufweist, in dem sowohl die Zuführleitung als auch die Rückführleitung verlaufen. Dies ist platzsparend und materialsparend, vereinfacht die Handhabung, und ist auch energetisch günstig. Insbesondere ist es möglich, mit der Rückführleitung die Zuführleitung von der Umgebung zumindest teilweise thermisch zu entkoppeln, oder die thermische Kopplung der Zuführleitung mit der Umgebung zu minimieren. Die Zuführleitung und die Rückführleitung verlaufen typischerweise zumindest in einem dem Nutz-Kryostaten nahen Abschnitt als gemeinsame Transportleitung und werden mit der gemeinsamen Transportleitung über einen gemeinsamen Heliumturm des Nutz-Kryostaten an den Nutz-Kryostaten angeschlossen, wobei bevorzugt wenigstens ein weiterer Heliumturm mit seinem vollen Querschnitt für einen Notablass von gasförmigem Helium aus dem Nutz-Heliumbehälter zur Verfügung steht, insbesondere im Quenchfall einer supraleitenden Magnetspule im Nutz-Kryostaten. Als Quench einer Magnetspule wird ein plötzlicher Verlust der Supraleitung bezeichnet, der zur plötzlichen Freisetzung der gespeicherten elektromagnetischen Energie als Wärme führt, und damit zu einer plötzlichen Verdampfung einer großen Menge an Helium führen kann.

Besonders vorteilhaft ist dabei eine Weiterentwicklung, bei der die Zuführleitung und die Rückführleitung koaxial innerhalb der gemeinsamen Vakuumbegrenzung verlaufen, wobei die Zuführleitung radial innerhalb der Rückführleitung liegt. Dadurch schirmt die Rückführleitung die Zuführleitung thermisch ab; die Rückführleitung wirkt als Strahlungsschild.

Bevorzugt ist auch eine Weiterentwicklung, bei der die Zuführleitung und die Rückführleitung zueinander parallel und nebeneinander liegend in der gemeinsamen Vakuumbegrenzung verlaufen. Dies ist baulich besonders einfach und kostengünstig einzurichten.

Bei einer weiteren Weiterbildung ist vorgesehen, dass die Rückführleitung mittels einem oder mehreren Abstandhaltern an der gemeinsamen Vakuumbegrenzung aufgehängt ist, und dass die Zuführleitung mit einem oder mehreren Abstandhaltern an der Rückführleitung aufgehängt ist, nicht aber an der gemeinsamen Vakuumbegrenzung. Dadurch wird, soweit es Wärmeleitung über die Abstandhalter angeht, die Zuführleitung von der Vakuumbegrenzung entkoppelt, und der Wärmeeintrag aus der Umgebung in die Zuführleitung, die das flüssige Helium führt, ist besonders gering.

Vorteilhaft ist eine Ausführungsform, bei der für einen Leitungsquerschnitt QZ der Zuführleitung und einen Leitungsquerschnitt QR der Rückführleitung gilt:

$$QR > QZ,$$

bevorzugt $QR \geq 3*QZ$,

besonders bevorzugt $QR \geq 5*QZ$. In diesem Fall kann die Vorrichtung auch bei einem sich etwas erwärmenden Strom von gasförmigem Helium sehr zuverlässig arbeiten, und Druckverluste in der Rückführleitung werden minimiert.

Bevorzugt ist weiterhin eine Ausführungsform, bei der die Zuführleitung und die Rückführleitung flexibel ausgebildet sind. Das erleichtert die Handhabung und das Verlegen der Zuführleitung und der Rückführleitung, vor allem bei einer nur zeitweiligen Installation für eine einzelne Befüllung des Nutz-Kryostaten mit flüssigem Helium.

Vorteilhaft ist eine Ausführungsform, bei der die Fördereinrichtung eine Zirkulationspumpe für flüssiges Helium in der Zuführleitung umfasst. Dadurch kann sehr effizient das flüssige Helium transferiert werden; die Förderrate an flüssigem Helium kann unmittelbar kontrolliert werden. Im Reservoir-Heliumbehälter kann ein vergleichsweise niedriger Druck eingestellt werden, da der (Gas-)Druck nicht zum Ausfördern des flüssigen Heliums benötigt wird.

Besonders bevorzugt ist eine Ausführungsform, bei der die Fördereinrichtung eine Zirkulationspumpe für gasförmiges Helium in der Rückführleitung umfasst. Dies ist baulich einfach einzurichten, und Zirkulationspumpen für gasförmiges Helium sind kostengünstig erhältlich sowie einfach und sicher zu betreiben. Gasblasenbildung und Kavitationseffekte, die in einer Pumpe in der Zuführleitung beachtet werden müssten, spielen hier keine Rolle.

Bei einer bevorzugten Weiterbildung dieser Ausführungsform ist vorgesehen, dass die Rückführleitung eine Leitungsschleife mit einem Eingangsbereich und einem Ausgangsbereich umfasst, wobei der Ausgangsbereich über einen Wärmetauscher mit dem Eingangsbereich thermisch gekoppelt ist,

und dass die Leitungsschleife die Zirkulationspumpe enthält,
insbesondere wobei die Zirkulationspumpe auf Raumtemperatur ist. Bei dieser Bauform braucht die Zirkulationspumpe nicht für einen kryogenen Betrieb eingerichtet sein, was baulich besonders einfach und auch besonders kosteneffizient ist.

Vorteilhaft ist auch eine Ausführungsform, die vorsieht,

dass die Fördereinrichtung einen Kolben im Reservoir-Heliumbehälter umfasst, wobei der Kolben im Reservoir-Heliumbehälter verfahrbar ist und einen ersten Teil des Reservoir-Heliumbehälters für gasförmiges Helium von einem zweiten Teil des Reservoir-Heliumbehälters für flüssiges Helium trennt, und dass die Zuführleitung im zweiten Teil abgeht, und die Rückführleitung in den ersten Teil führt. Mit dem Kolben (auch Schieber genannt) kann auf einfache Weise flüssiges Helium aus dem Reservoir ausgefördert werden. Eine Zirkulationspumpe ist dann nicht nötig. Zudem können die Zuführleitung und die Rückführleitung zwischen dem Nutz-Kryostaten und dem Reservoir-Kryostaten auf einfache Weise vollständig als gemeinsame Transportleitung verlaufen.

Bevorzugt ist weiterhin eine Ausführungsform, bei der die Vorrichtung weiterhin eine Steuereinrichtung zur Regelung eines Heliumdrucks in der Vorrichtung und/oder in dem Nutz-Heliumbehälter umfasst, insbesondere wobei die Steuereinrichtung dazu ausgebildet ist, die Fördereinrichtung anzusteuern. Typischerweise wird überall in der Vorrichtung (insbesondere im Reservoir-Heliumbehälter) und im Nutz-Heliumbehälter ein Heliumdruck oberhalb des Atmosphärendrucks eingeregelt, um ein Eindringen von Luft zu minimieren. Über die Steuereinrichtung kann insbesondere ein für das Ausfördern des flüssigen Heliums ausreichender Differenzdruck zwischen Reservoir-Heliumbehälter und Nutz-Heliumbehälter eingerichtet werden, insbesondere unter Ansteuerung der Fördereinrichtung. Durch die Steuereinrichtung kann auch im Falle eines hohen Drucks im System, etwa im Nutz-Heliumbehälter, eine Öffnung wenigstens eines Ablassventils ausgelöst werden. Es ist alternativ oder zusätzlich auch möglich, ein oder mehrere, von der Steuereinrichtung unabhängige (z.B. passive, nur durch Federn vorgespannte) Überdruckventile vorzusehen. Die Steuereinrichtung ist typischerweise an einen Gasdrucksensor im Nutz-Heliumbehälter angeschlossen. Typischerweise umfasst die Steuereinrichtung auch einen Gasdrucksensor im Reservoir-Heliumbehälter.

Bevorzugt ist eine Weiterbildung dieser Ausführungsform, bei der die Vorrichtung weiterhin umfasst:

- eine Heizeinrichtung, insbesondere angeordnet im Reservoir-Heliumbehälter; und/oder
- einen Helium-Druckgasspeicher mit einem Steuerventil, insbesondere zum Anschluss an den Nutz-Heliumbehälter,

insbesondere wobei die Steuereinrichtung dazu ausgebildet ist, die Heizeinrichtung und/oder das Steuerventil anzusteuern. Durch die Heizeinrichtung oder den Helium-Druckgasspeicher ist es auf einfache Weise möglich, die Gasmenge - und so den Druck - im System zu erhöhen, insbesondere um einen geringfügigen Überdruck im System sicherzustellen, der ein Eindringen von Luft aus der Umgebung minimiert. Die Heizeinrichtung kann beispielsweise an einem unteren Ende der Zuführleitung, das in das flüssige Helium im Reservoir-Heliumbehälter ragt, angeordnet sein. Die Heizeinrichtung ist typischerweise elektrisch. Der Helium-Druckgasspeicher ("Druckgasflasche") ist typischerweise auf Raumtemperatur.

Vorteilhafter Weise ist bei einer Ausführungsform vorgesehen, dass die Vorrichtung einen Laborverflüssiger für Helium umfasst, wobei der Laborverflüssiger umfasst:

- den Reservoir-Kryostaten mit dem Reservoir-Heliumbehälter, und
- einen Kryokühler zur Verflüssigung von gasförmigem Helium. Der LaborVerflüssiger stellt den Reservoir-Kryostaten zur Verfügung. Der Laborverflüssiger weist eine verhältnismäßig geringe Verflüssigungsleistung auf, typischerweise 40 Liter/Tag oder weniger, meist 25 Liter/Tag oder weniger, und in vielen Fällen etwa 20 Liter/Tag. Im Laufe seines regulären Betriebs kann der Laborverflüssiger flüssiges Helium ansammeln, das im Laufe des regulären Betriebs einer Anwendung am Nutz-Kryostaten (etwa einer NMR-Apparatur) als gasförmiges Helium abgedampft ist und vom Kryokühler verflüssigt wurde. Mit dem Kryokühler kann insbesondere das angesammelte flüssige Helium unter den Siedepunkt von flüssigem Helium bei Atmosphärendruck (ca. 1 bar), also unter 4,2 K, abgekühlt werden, wodurch eine Kältereserve für den Transfer des flüssigen Heliums beim Nachfüllen des Nutz-Kryostaten vorgehalten werden kann. Diese Kältereserve ("Kälteenergie") kann Wärmeinträge in das System während des Transfers des flüssigen Heliums ausgleichen, und dadurch einen unerwünscht hohen Druckanstieg im System reduzieren oder vermeiden. Der Kryokühler kann die Kältereserve über lange Zeit (z.B. über mehrere Wochen) aufbauen, wodurch dieser nur wenig über den Bedarf des regulären Betriebs dimensioniert werden muss.

*Erfindungsgemäße Kryobehälter-Anordnungen*

In den Rahmen der vorliegenden Erfindung fällt auch eine Kryobehälter-Anordnung, umfassend eine oben beschriebene, erfindungsgemäße Vorrichtung sowie den Nutz-Kryostaten mit dem Nutz-Heliumbehälter,

> wobei die Zuführleitung an den Nutz-Heliumbehälter angeschlossen ist und in den Nutz-Heliumbehälter führt,
> und wobei die Rückführleitung an den Nutz-Heliumbehälter angeschlossen ist und von dem Nutz-Heliumbehälter abgeht. Aus der Vorrichtung kann der Nutz-Heliumbehälter mit flüssigem Helium befüllt werden, wobei Transferverluste von Helium, insbesondere von flüssigem Helium, minimiert werden können. Die Verbindung zwischen der Vorrichtung zum Transfer von flüssigem Helium ("Transfervorrichtung") einerseits und dem Nutz-Kryostaten mit dem Nutz-Heliumbehälter andererseits ist typischerweise lösbar (bzw. reversibel) ausgebildet; dadurch kann die Transfervorrichtung während des regulären Betriebs vom Nutz-Kryostaten entfernt werden und ggf. auch bei einer Vielzahl von NutzKryostaten im Wechsel eingesetzt werden.

Vorteilhaft ist eine Ausführungsform der erfindungsgemäßen Kryobehälter-Anordnung, bei der die Kryobehälter-Anordnung weiterhin wenigstens einen Drucksensor im Bereich des Nutz-Heliumbehälters umfasst,
insbesondere wobei der Drucksensor an eine Steuereinrichtung der Vorrichtung angeschlossen ist. Mit dem Drucksensor kann der Gasdruck im Nutz-Heliumbehälter überwacht werden, insbesondere um diesen mit Hilfe der Steuereinrichtung oberhalb des Umgebungsdrucks (Atmosphärendruck) zu halten, um ein Eindringen von Luft in das System zu minimieren.

*Erfindungsgemäße Verfahren zum Transfer von flüssigem Helium*

In den Rahmen der vorliegenden Erfindung fällt weiterhin ein Verfahren zum Transfer von flüssigem Helium aus einem Reservoir-Heliumbehälter eines Reservoir-Kryostaten in einen Nutz-Heliumbehälter eines Nutz-Kryostaten,

> wobei durch eine Zuführleitung für flüssiges Helium, die vom Reservoir-Heliumbehälter abgeht und an den Nutz-Heliumbehälter angeschlossen ist, in dem Reservoir-Heliumbehälter bevorratetes flüssiges Helium aus dem Reservoir-Heliumbehälter in den Nutz-Heliumbehälter gefördert wird,
> das dadurch gekennzeichnet ist,
> dass gleichzeitig durch eine Rückführleitung für gasförmiges Helium, die an den Nutz-Heliumbehälter angeschlossen ist und in den Reservoir-Heliumbehälter führt, gasförmiges Helium aus dem Nutz-Heliumbehälter in den Reservoir-Heliumbehälter zurückgeführt wird. Dieses Verfahren minimiert Transferverluste von Helium, insbesondere von flüssigem Helium, bei Nachbefüllen des NutzKryostaten mit flüssigem Helium aus dem Reservoir-Kryostaten. Das über die Rückführleitung in den Reservoir-Heliumbehälter zurückgeführte Helium geht nicht verloren, braucht nicht zwischengespeichert zu werden und kann dabei helfen, das flüssige Helium aus dem Reservoir-Heliumbehälter herauszufördern, insbesondere herauszudrücken. Typischerweise beträgt beim Transfer des flüssigen Heliums die Förderleistung wenigstens 8 kg/h, meist wenigstens 12 kg/h. Im Rahmen des Verfahrens kann eine oben beschriebene, erfindungsgemäße Vorrichtung oder auch eine oben beschriebene, erfindungsgemäße Kryobehälter-Anordnung eingesetzt werden. Der Nutz-Kryostat kann insbesondere der Kryostat eines NMR-Magneten sein.

Bevorzugt ist eine Variante des erfindungsgemäßen Verfahrens, die vorsieht, dass die Volumenströme von flüssigem Helium durch die Zuführleitung und von gasförmigem Helium durch die Rückführleitung näherungsweise gleich sind. Mit anderen Worten, der Transfer des flüssigen Heliums erfolgt in einem geschlossenen Kreislauf zwischen Reservoir-Heliumbehälter und Nutz-Heliumbehälter (ohne Auslass in die Umgebung oder zusätzliche Zwischenspeicherung von Helium außerhalb des Reservoir-Heliumbehälters und des Nutz-Heliumbehälters). Der Transfer ist hoch effizient und minimiert Transferverluste. Typischerweise unterscheiden sich die Volumenströme von flüssigem Helium durch die Zuführleitung und von gasförmigem Helium durch die Rückführleitung um 10% oder weniger, meist 5% oder weniger, und bevorzugt 1% oder weniger, bezogen auf den kleineren der Volumenströme (beim Heliumtransfer unter stabilen Bedingungen).

Vorteilhaft ist auch eine Variante, die vorsieht,

dass für eine Temperatur TLHe des flüssigen Heliums im Reservoir-Heliumbehälter zumindest zu Beginn des Transfers des flüssigen Heliums gilt:

$$TLHe < 4,2\ K,$$

bevorzugt TLHe ≤ 3,6 K,
besonders bevorzugt TLHe ≤ 3,0 K,
insbesondere wobei die die Temperatur TLHe des flüssigen Heliums im Reservoir-Heliumbehälter vor Beginn des Transfers des flüssigen Heliums mit einem Kryokühler eines Laborverflüssigers eingestellt wurde, in welchen der Reservoir-Kryostat mit dem Reservoir-Heliumbehälter integriert ist. Durch das flüssige Helium mit einer Temperatur deutlich unter dem Siedepunkt (4,2 K bei Atmosphärendruck) wird ein Kältevorrat eingerichtet, der einen Wärmeeintrag in das System während des Transfers von flüssigem Helium in den Nutz-Kryostaten kompensieren kann, und so einen Druckanstieg im System begrenzen kann; insbesondere kann vom Nutz-Kryostaten in den Reservoir-Kryostaten rückgefördertes

Heliumgas mittels des Kältevorrats wieder abgekühlt werden, und ggf. auch rückverflüssigt werden. Wird das flüssige Helium im Reservoir-Heliumbehälter unter die Temperatur des Phasenübergangs zum superfluiden Helium abgekühlt (2,17 K bei Atmosphärendruck), steht durch die hohe spezifische Wärme im Bereich des Phasenübergangs ein besonders großer Kältevorrat zu Verfügung.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1 zeigt in einer schematischen Darstellung eine erste Ausführungsform einer erfindungsgemäßen Kryobehälter-Anordnung mit Vorrichtung zum Transfer von flüssigem Helium, mit einer kalten Zirkulationspumpe in der Rückführleitung;

Fig. 2 zeigt in einer schematischen Darstellung eine zweite Ausführungsform einer erfindungsgemäßen Kryobehälter-Anordnung mit Vorrichtung zum Transfer von flüssigem Helium, mit einer Zirkulationspumpe in der Zuführleitung;

Fig. 3 zeigt in einer schematischen Darstellung eine dritte Ausführungsform einer erfindungsgemäßen Kryobehälter-Anordnung mit Vorrichtung zum Transfer von flüssigem Helium, mit einer raumtemperaturwarmen Zirkulationspumpe in einer Leitungsschleife der Rückführleitung;

Fig. 4 zeigt in einer schematischen Darstellung einen Ausschnitt einer vierten Ausführungsform einer erfindungsgemäßen Kryobehälter-Anordnung, mit einer gemeinsamen Transportleitung mit einer gemeinsamen Vakuumbegrenzung;

Fig. 5 einen schematischen Querschnitt durch eine erste Bauform einer gemeinsamen Transportleitung für die Erfindung, mit koaxialer Zuführleitung und Rückführleitung;

Fig. 6 einen schematischen Querschnitt durch eine zweite Bauform einer gemeinsamen Transportleitung für die Erfindung, mit paralleler Zuführleitung und Rückführleitung;

Fig. 7 zeigt in einer schematischen Darstellung eine fünfte Ausführungsform einer erfindungsgemäßen Kryobehälter-Anordnung mit Vorrichtung zum Transfer von flüssigem Helium, wobei der Reservoir-Kryostat in einen Laborverflüssiger integriert ist;

Fig. 8     zeigt in einer schematischen Darstellung eine sechste Ausführungsform einer erfindungsgemäßen Kryobehälter-Anordnung mit Vorrichtung zum Transfer von flüssigem Helium, mit einem vertikal verfahrbaren Kolben in einem Reservoir-Heliumbehälter mit starren Wänden;

Fig. 9     zeigt in einer schematischen Darstellung eine siebte Ausführungsform einer erfindungsgemäßen Kryobehälter-Anordnung mit Vorrichtung zum Transfer von flüssigem Helium, mit einem vertikal verfahrbaren Kolben in einem Reservoir-Heliumbehälter mit teilweise als Faltenbalg ausgebildeten Wänden;

Fig. 10    zeigt in einer schematischen Darstellung einen Ausschnitt einer achten Ausführungsform einer erfindungsgemäßen Kryobehälter-Anordnung mit Vorrichtung zum Transfer von flüssigem Helium, mit einem horizontal verfahrbaren Kolben in einem Reservoir-Heliumbehälter mit starren Wänden, wobei der Kolben zusammen mit einem Faltenbalg einen Teilraum im Reservoir-Heliumbehälter begrenzt.

*Hintergrund der Erfindung*

Im Rahmen der vorliegenden Erfindung soll flüssiges Helium möglichst nachhaltig genutzt werden. Supraleitende Magnete - zum Beispiel für NMR und MRI - werden üblicherweise mit flüssigem Helium gekühlt. Helium wird üblicherweise als Nebenprodukt bei der Erdgasförderung gewonnen oder aus sogenannten "Heliumquellen" (Gasquellen, die einen ungewöhnlich hohen Anteil von Helium aufweisen) gefördert. Helium ist eine knappe Ressource, deren Verfügbarkeit am Weltmarkt immer geringer wird. Dies ist ein Trend, der sich in Zukunft noch verstärken wird.

Die Knappheit an Helium führt zu ständig steigenden Preisen, was den Betrieb von Geräten, die Helium benötigen (z.B. supraleitende Magnete) immer teurer macht. Außerdem herrscht gelegentlich erhebliche Unsicherheit, ob flüssiges Helium zu einem gewissen Zeitpunkt überhaupt verfügbar sein wird, was dazu führt, dass Anlagen, die flüssiges Helium benötigen, außer Betrieb genommen werden müssen.

Flüssiges Helium wird vom Lieferanten zum Verbraucher (z.B. betrebend einen NMR-Magneten) mittels sogenannter "Transportdewar" (hier auch als ReservoirKryostaten bezeichnet) transportiert. Dabei handelt es sich um vakuumisolierte Gefäße, die typischerweise mit Rollen ausgestattet sind. Das flüssige Helium muss dann mittels einer vakuumisolierten Transferleitung vom Transportdewar in den NMR-Magneten oder einen anderen Nutz-Kryostaten umgefüllt werden. Die hier beschriebene Erfindung hilft dabei, diesen Transfer effizienter zu gestalten.

Viele Verbraucher investieren auch in Anlagen zur Heliumrückgewinnung, bei denen das aus dem Gerät (z.B. dem NMR-Magnet) verdampfte Heliumgas, bzw. das bei einem Transfer aus dem Gerät ausgedrückte Heliumgas, aufgefangen wird und dann einem Druckspeicher oder Heliumverflüssiger zugeführt wird. Das von einem Heliumverflüssiger wieder verflüssigte Helium kann dann wieder dem NMR-Magneten zur Kühlung der supraleitenden Spule zugeführt werden.

Rückgewinnungssysteme verfügen typischerweise entweder über einen großen Niederdruckspeicher zum Zwischenspeichern des gasförmiges Heliums vor dessen Verflüssigung oder Kompression zur platzsparenden Lagerung (etwa einen großvolumigen Ballonspeicher, der vergleichsweise viel Platz benötigt) oder über einen Hochdruckspeicher mit vorgeschaltetem, sehr leistungsstarkem und damit teurem Kompressor, der für den Heliumstrom, der beim Nachfüllen des flüssigen Heliums in den Nutz-Kryostaten aus dem Nutz-Kryostaten herausgedrückt wird, unmittelbar ausgelegt sein muss. Das aus dem Nutz-Kryostaten entweichende Helium könnte theoretisch auch durch eine entsprechend dimensioniere Kältemaschine zur platzsparenden Lagerung im flüssigen Zustand direkt abgekühlt und verflüssigt werden. Die Kältemaschine des Rückgewinnungssystems muss dann für den sehr hohen Heliumgasstrom, der beim Nachfüllen des flüssigen Heliums in den Nutz-Kryostaten aus dem Nutz-Kryostaten herausgedrückt wird, unmittelbar ausgelegt sein. In letzterem Fall wäre die Kältemaschine sehr teuer, und würde während des Normalbetriebs der Anwendung nicht annähernd ausgelastet. Die hier beschriebene Erfindung ermöglicht es, auf einen großvolumigen Ballonspeicher, überdimensionierte Kompressoren oder überdimensionierte Kältemaschinen zu verzichten.

Ein Heliumtransfer läuft üblicherweise wie folgt ab (siehe auch die eingangserwähnte Formendruckschrift "NMR Magnet System UltraShield Magnets (English version) User Manual Version 006" der Bruker BioSpin AG):

• Der Transportdewar wird in die Nähe des NMR Magnets verbracht (wenige Meter Abstand).

• Die warme Transferleitung wird in den Transportdewar gesteckt, sodass deren Ende unterhalb der Flüssigkeitsoberfläche zu liegen kommt.

• Durch den Wärmeeintrag der warmen Transferleitung verdampft Helium im Transportdewar - dadurch steigt der Druck im Transportdewar, und flüssiges Helium wird in die Transferleitung gedrückt, die dadurch abgekühlt wird. Das Helium, das während des Abkühlvorgangs aus dem Ende der Leitung entweicht, wird üblicherweise nicht aufgefangen und geht in die Atmosphäre verloren. Für eine typische Transferleitung mit wenigen Metern Länge werden zum Abkühlen einige Liter flüssiges Helium benötigt.

- Sobald das Helium, das aus dem Ende der Leitung entweicht, das dem Transportdewar abgewandt ist, ausreichend kalt ist (d.h. die Transferleitung ausreichend abgekühlt ist), wird die Transferleitung mit dem NMR Magnet verbunden (bzw. deren Ende wird in den Kryostaten des NMR-Magneten gesteckt).

- Nachdem die Transferleitung mit dem NMR Magnet verbunden wurde, fließt flüssiges Helium vom Transportdewar in den NMR-Magneten. Der Massenfluss wird getrieben durch den Druckunterschied, der zwischen dem Transportdewar und NMR-Magneten herrscht. Im Transportdewar hat sich durch das Einstecken der Transferleitung wie oben erwähnt ein Überdruck aufgebaut. Der Ausgang des Magneten (der Anschluss, aus dem Helium aus dem NMR-Magneten entweicht) führt entweder direkt in die Atmosphäre oder ist mit einem Rückgewinnungssystem verbunden, das sicherstellt, dass am Ausgang immer annähernd Atmosphärendruck herrscht.

- Üblicherweise reicht der Druckaufbau im Transportdewar, der sich durch den Wärmeeintrag beim Einstecken der Transferleitung einstellt, nicht aus, um die gewünschte Menge Helium zu transferieren. Der Druck im Transportdewar wird deshalb künstlich hoch gehalten, indem der Transportdewar mit Heliumgas aus einer Druckflasche über einen Druckregler konstant hoch gehalten wird. Typischerweise liegt der Überdruck, der im Transportdewar eingestellt wird, bei etwa 50 - 100 mbar.

Bevor ein Heliumtransfer gestartet wird, ist der Heliumtank des NMR-Magneten nicht leer - der Tank ist zum Großteil mit gasförmigem Helium bei einer Temperatur von etwa 4,2 K gefüllt. Wenn sich der Heliumtank im Laufe des Transfers langsam mit flüssigem Helium füllt, wird das kalte gasförmige Helium, das sich vor Beginn des Transfers im Heliumtank befand, sukzessive aus dem Heliumtank gedrückt und entweicht über den Ausgang des Magneten.

Gasförmiges Helium bei 4,2 K und Atmosphärendruck hat eine Dichte von 16,5 g/l. Flüssiges Helium bei 4,2 K und Atmosphärendruck hat eine Dichte von 125 g/l. Werden beispielsweise 100 Liter flüssiges Helium - also 12,5 kg Helium - transferiert, werden demnach 100 Liter gasförmiges Helium - also 1,65 kg - aus dem Magneten gedrückt. Das entspricht 13,2 Litern flüssigen Heliums oder 13,2 Prozent der transferierten Menge.

Im schlimmsten Fall entweicht diese Heliummenge über den Ausgang des Magnets in die Atmosphäre. Da dies nicht nachhaltig ist, entscheiden sich viele Anwender für die Installation eines Gasballonspeichers, der ausreichend groß dimensioniert ist, um das beim Heliumtransfer anfallende Helium (die "Transferverluste") aufzufangen und einem Hochdruckspeicher und/oder Verflüssiger zuzuführen. Im Leitungssystem, das zum Gasballon führt, bzw. im Ballon selbst, erwärmt sich das gasförmige Helium auf Raumtemperatur. Oftmals wird das Gas auch absichtlich in dem Gasballon vorgeschalteten Wärmetauschern erwärmt, da Gasballone üblicherweise nicht kompatibel mit tiefen Temperaturen sind (z.B. aufgrund von Eisbildung, Kondenswasser oder Materialversprödung). Die Erwärmung des Heliumgases führt zu einer großen Volumenzunahme des Gases. 100 Liter gasförmigen Heliums bei Atmosphärendruck und 4,2 K entsprechen etwa 10.000 Litern (also 10 m$^3$) bei Atmosphärendruck und Raumtemperatur.

Bei einem Heliumtransfer in einen NMR-Magneten werden - abhängig vom Magnettyp - typischerweise zwischen 100 und 400 Liter flüssiges Helium transferiert. Ein Transfer dauert etwa eine Stunde. In dieser Zeit fallen also zwischen 10 und 40 Kubikmeter gasförmiges Helium bei Raumtemperatur an, die in einem Gasballon gespeichert bzw. von einem Rückgewinnungssystem prozessiert (z.B. in Druckspeicher komprimiert) werden müssen. Diese Transferverluste sind äquivalent zu 13 l/h bis 50 l/h flüssigen Heliums (oder zwischen etwa 1,6 und 6,6 kg Helium pro Stunde).

Zum Vergleich ist der Heliumverbrauch einiger typischer NMR-Magnete im Normalbetrieb angegeben:

- 400 MHz: 0.013 l/h
- 500 MHz: 0.013 l/h
- 600 MHz: 0.016 l/h
- 700 MHz: 0.026 l/h
- 800 MHz: 0.05 l/h
- 1.2 GHz: 0.25 l/h.

Es ist offensichtlich, dass beim Transfer des flüssigen Heliums die Transferverluste pro Zeiteinheit weit größer sind als der Heliumverbrauch im Normalbetrieb, und dass Rückgewinnungssysteme (wenn sie auch den Heliumtransfer prozessieren können sollen) deshalb für eine große Spitzenlast ausgelegt werden müssen, die jedoch nur verhältnismäßig selten (typsicherweise im Abstand mehrerer Monate für nur ein bis zwei Stunden) auftritt. Besonders die Gasspeicherballone mit einem Volumen von vielen Kubikmetern sind in NMR-Laboratorien schwer unterzubringen und verschlingen teures Volumen in einem Gebäude. Außerdem bringen Gasballone andere Nachteile mit sich. Durch Diffusion durch die Oberfläche des Ballons kann z.B. Helium entweichen, und Verunreinigungen (Feuchtigkeit, Bestandteile von Luft) können in den Heliumkreislauf eindringen.

Vor kurzem wurden kleine Rückgewinnungssysteme auf den Markt gebracht, die für die Abdampfraten im Normalbetrieb dimensioniert sind, vgl. die eingangs erwähnte Firmendruckschrift Firmendruck "Heliosmart Recovery Technical Specifications" der Bruker BioSpin. Bei solchen Systemen, die sehr preiswert und wegen ihrer Kompaktheit einfach zu installieren sind, wird bewusst in Kauf genommen, dass Transferverluste nicht aufgefangen werden können und deshalb verloren gehen.

Die gängige Praxis, zu Anfang des Prozesses raumtemperaturwarmes, gasförmiges Helium aus einer Gasflasche in den Transportdewar einzuleiten, oder auch im Transportdewar Wärme zu dissipieren, die zur Verdampfung von flüssigem Helium führt und so im Transportdewar Druck aufbaut, sind außerdem energetisch ungünstig. Flüssiges Helium wird verschwendet, das ursprünglich mit großem Energieaufwand verflüssigt wurde.

Es gibt diverse Konzepte, im Normalbetrieb von Anwendungen Helium zur Kühlung in einem geschlossenen Kreislauf zirkulieren zu lassen, beispielsweise wie in der eingangs erwähnten US 6 442 948 B1 beschrieben. Im Falle einer solchen Zirkulation ist es nicht notwendig, große Mengen gasförmigen Heliums in kurzer Zeit zu prozessieren. Allerdings sind entsprechende Anlagen in Anschaffung und Betrieb meist teuer und aufwändig, und es können diverse Betriebsstörungen auftreten. Zudem können bei diesen Anlagen durch den im Normalbetrieb laufenden Kryokühler leicht Vibrationen in den Nutz-Kryostaten eingebracht werden, die die gewünschte Anwendung (beispielsweise NMR-Messungen) beeinträchtigen können. Lösungen, die auf Kühlung in einem geschlossenen Kreislauf beruhen, können auch nicht ohne Weiteres bei bereits existierenden Systemen nachgerüstet werden, und kommen deshalb für alle aktuellen Betreiber auch nicht in Frage.

Die Erfindung betrifft hingegen Anlagen, bei denen gelegentlich eine große Menge flüssigen Heliums in kurzer Zeit transferiert wird, um in einem Kryostaten (Nutz-Kryostaten) dann über lange Zeit für die Kühlung zu Verfügung zu stehen. Vorteilhaft an einem solchen "Batch-Transfer" ist, dass der Kryostat lange Zeit unabhängig betrieben werden kann, ohne auf das kontinuierlich zirkulierende Helium zur Kühlung angewiesen zu sein. Dies führt zu besonders hoher Zuverlässigkeit und auch Vibrationsarmut, was für viele Anwendungen - z.B. in der NMR - wichtig ist. Bei einem solchen Batchtransfer müssen jedoch, wie oben aufgezeigt, großen Mengen kalten Heliumgases ausgedrückt und prozessiert werden, was mittels der vorliegenden Erfindung geleistet werden kann. Der Großteil (schätzungsweise > 99%) aller existierenden NMR Spektrometer mit supraleitenden Magneten weltweit werden im Batch-Transfer-Verfahren betrieben.

*Überblick über die Erfindung*

Im Rahmen der Erfindung können Heliumtransfers mit einer geeigneten Vorrichtung so durchgeführt werden, dass keine großen Mengen Heliumgas bei Raumtemperatur anfallen. Dies wird insbesondere dadurch erreicht, dass kaltes Heliumgas während des Transfers durch eine thermisch isolierte Leitung aus dem NMR-Magneten (oder allgemeiner dem Nutz-Kryostaten) abgeleitet wird und im freiwerdenden Volumen im Transportdewar (auch genannt Reservoir-Kryostat) gespeichert und dort teilweise auch zum Druckaufbau benutzt wird. Die für die Zirkulation nötige Druckdifferenz kann mittels einer Pumpe eingerichtet sein, die speziell für kalte Fluide geeignet ist.

Die Zirkulationspumpe kann entweder in der Leitung für flüssiges Helium, die zum NMR Magnet führt, angeordnet werden, oder in der Leitung für gasförmiges Helium, die vom Magnet wegführt. Letzteres ist vorteilhaft, weil die Anforderung vermeidet, eine siedende Flüssigkeit (Helium bei 4,2 K und Atmosphärendruck) zu pumpen. Siedende Flüssigkeiten sind in Pumpen schwierig zu handhaben, etwa aufgrund der Gefahr der Bildung von Gasblasen/Kavitation.

Aus Gründen, die hauptsächlich mit Aspekten der Betriebssicherheit und Zuverlässigkeit zu tun haben, sollte darauf geachtet werden, dass sich an möglichst keiner Stelle im Heliumkreislauf - besonders nicht im NMR-Magneten - ein Druck einstellt, der unterhalb des Atmosphärendrucks liegt. Bei Undichtigkeiten im System würde dies dazu führen, dass Luft oder andere Verunreinigungen in den NMR-Magneten gesaugt werden, dort ausfrieren und zu Vereisungen und Blockagen führen. Der Druck im NMR-Magneten kann mittels eines Druckregelventils und einem Anschluss an einen Gasspeicher (über einen Druckregler) realisiert werden.

Es ist auch vorteilhaft, eine elektrische Heizung vorzusehen, mit der die Gasmenge im Kreislauf erhöht werden kann, um bei Bedarf einen Druckanstieg hervorrufen zu können. Diese Heizung kann in das Ende der Transferleitung, das im Transportdewar ins flüssige Helium ragt, angeordnet werden. Dies hat den Vorteil, dass die Heizung Teil der Transfervorrichtung ist, und weder am NMR-Magneten noch am Transportdewar Änderungen vorgenommen werden müssen.

Die für den Heliumtransfer nötige Druckdifferenz zwischen Transportdewar (bzw. Reservoir-Kryostat) und NMR-Magnet (bzw. Nutz-Kryostat) kann durch den Einsatz einer drehzahlgeregelten Pumpe erreicht werden, deren Pumpleistung in Abhängigkeit von mittels Sensoren gemessenen Drücken geregelt wird. Ein Drucksensor kann auch Teil der Transfervorrichtung sein kann. Ebenfalls möglich ist eine Zweipunktregelung, bei der die Pumpe in variablen Intervallen ein- und ausgeschaltet wird.

Alternativ zu einer Pumpe, die für kalte Fluide geeignet ist, kann auch eine Pumpe bei Raumtemperatur in Kombination mit einem Wärmetauscher verwendet werden. An dieser Stelle empfiehlt sich vor allem ein Gegenstromwärmetauscher, beispielsweise in Rohr-in-Rohr-Bauweise.

*Vorstellung bevorzugter Ausführungsformen*

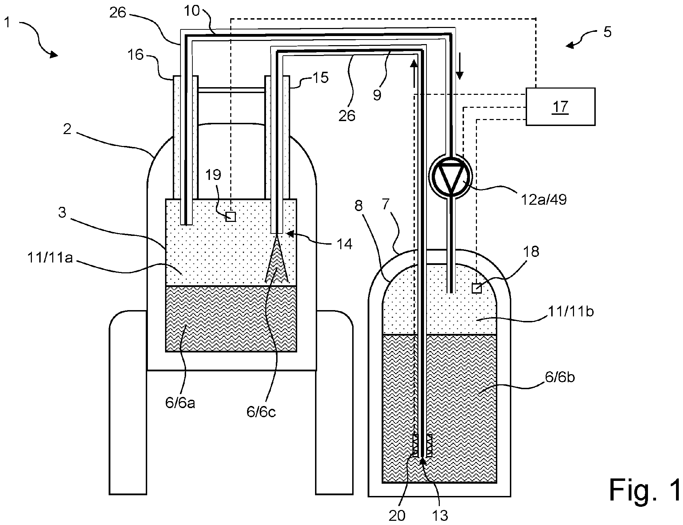

Eine erste, bevorzugte Ausführungsform einer Kryostaten-Anordnung 1 gemäß der Erfindung ist in **Fig. 1** dargestellt.

Die Kryostaten-Anordnung 1 umfasst einen Nutz-Kryostaten 2, der hier zu einem NMR-Magneten gehört und einen vakuumisolierten Nutz-Heliumbehälter 3 für flüssiges Helium 6/6a aufweist, sowie eine Vorrichtung 5 zum Transfer von flüssigem Helium 6. Diese Vorrichtung 5 umfasst einen Reservoir-Kryostaten 7 (auch genannt Transportdewar) mit einem vakuumisolierten Reservoir-Heliumbehälter 8 für flüssiges Helium 6/6b, eine vakuumisolierte Zuführleitung 9 für flüssiges Helium 6 und eine vakuumisolierte Rückführleitung 10 für gasförmiges Helium 11. In der Rückführleitung 10 ist als Fördereinrichtung 49 eine Zirkulationspumpe 12a für kaltes, gasförmiges Helium angeordnet.

Für einen Transfer von flüssigem Helium 6/6b aus dem Reservoir-Heliumbehälter 8 durch die Zuführleitung 9 in den Nutz-Heliumbehälter 3 wird mit der Zirkulationspumpe 12a kaltes, gasförmiges Helium 11a aus dem Nutz-Heliumbehälter 3 abgesaugt und in den Reservoir-Heliumbehälter 8 eingeleitet ("direkter Strom").

Dadurch steigt der Gasdruck des gasförmigen Heliums 11/11b im Reservoir-Heliumbehälter 8 an, und flüssiges Helium 6/6b wird aus dem Reservoir-Heliumbehälter 8 in das Reservoirkryostaten-seitige Ende 13 der Zuführleitung 9 in die Zuführleitung 9 gedrückt, und flüssiges Helium 6/6c tritt am Nutzkryostaten-seitigen Ende 14 der Zuführleitung 9 aus und fließt dem Nutz-Kryostaten 2 zu ("indirekter Strom").

Die Zirkulationspumpe 12a wird von einer elektronischen Steuereinrichtung 17 angesteuert, die auch einen Drucksensor 18 im Reservoir-Heliumbehälter 8 und einen Drucksensor 19 im Nutz-Heliumbehälter 3 überwacht. Weiterhin ist hier noch eine elektrische Heizeinrichtung 20 im Bereich des Endes 13 der Zuführleitung 9 angebracht, die in das flüssige Helium 6/6b des Reservoir-Heliumbehälters 8 eingetaucht ist; diese Heizeinrichtung 20 wird ebenfalls von der Steuereinrichtung 17 angesteuert. Das Anordnen der Heizeinrichtung 20 in der flüssigen Phase garantiert ein besonders schnelles Ansprechverhalten der Druckregelung (bzw. Druckdifferenzregelung). Alternativ kann die Heizeinrichtung auch in der Gasphase angeordnet werden - dies kann energetische Vorteile haben (ein gewisser Druckanstieg kann mit einem geringeren Verlust an flüssigem Helium 6 erreicht werden), die Druckregelung reagiert dann aber langsamer. Die Steuereinrichtung 17 kann über die Zirkulationspumpe 12a bewirken, dass der Druck im Reservoir-Heliumbehälter 8 ein wenig über dem Druck im Nutz-Heliumbehälter 3 liegt, so dass flüssiges Helium 6/6c mit der gewünschten Flussrate in durch die Zuführleitung 9 in den Nutz-Heliumbehälter 3 fließt. Hierfür reicht eine Druckdifferenz von 50-100 mbar meist aus. Sollte der Druck im System insgesamt zu niedrig werden, insbesondere im Nutz-Heliumbehälter 3 oder im Reservoir-Heliumbehälter 8 unter den Umgebungsdruck (Atmosphärendruck von ca. 1 bar) fallen, so kann als Notfallmaßnahme die Steuereinrichtung 17 mittels der Heizrichtung 20 ein wenig Helium 6b im Reservoir-Heliumbehälter 8 verdampfen. Mit dem zusätzlichen Heliumgas erhöht sich der Gasdruck im System.

In der gezeigten Ausführungsform sind die Zuführleitung 9 und die Rückführleitung 10 getrennt ausgeführt, und jede der Leitungen 9, 10 wird an einem eigenen Magnetturm (Heliumturm) 15, 16 am Nutz-Kryostaten 2 angeschlossen. Der Reservoir-Heliumbehälter 8 im Reservoir-Kryokühler 7 hat ein Speichervolumen von typischerweise 100-400 Liter.

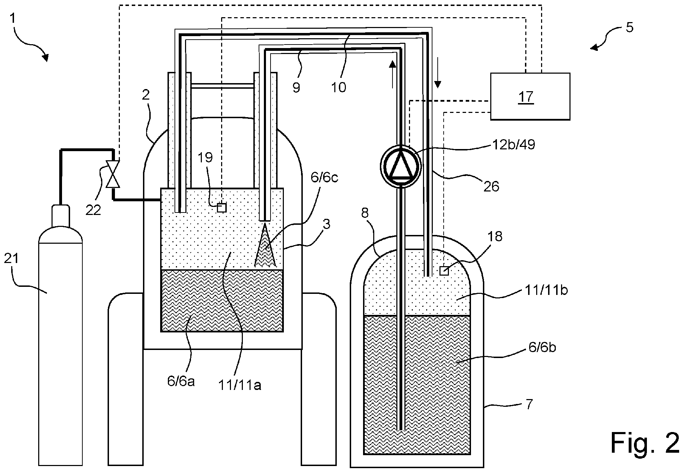

Eine zweite Ausführungsform einer Kryostaten-Anordnung 1 gemäß der Erfindung ist in **Fig. 2** dargestellt; diese zweite Ausführungsform ähnelt in weiten Teilen der Bauform von Fig. 1, so dass hier nur die wesentlichen Unterschiede erläutert werden.

In der gezeigten Ausführungsform ist die Fördereinrichtung 49 ausgebildet als eine Zirkulationspumpe 12b, die in der Zuführleitung 9 angeordnet ist und flüssiges Helium 6/6b aus dem Reservoir-Heliumbehälter 8 durch die Zuführleitung 9 in den Nutz-Heliumbehälter 3 pumpt ("direkter Strom"). Das in den Nutz-Heliumbehälter 3 einfließende flüssige Helium 6/6c drückt ein entsprechendes Volumen an gasförmigem Helium 11/11a durch die Rückführleitung 10 in den Reservoir-Heliumbehälter 8 ("indirekter Strom"). Im Reservoir-Heliumbehälter 8 sammelt sich das gasförmige Helium 11/11b oberhalb des flüssiges Heliums 6/6b an und kann dabei helfen, das flüssige Helium 6/6b in die Zuführleitung 9 zu fördern.

In der gezeigten Ausführungsform ist ein raumtemperaturwarmer Helium-Druckgasspeicher 21 vorgesehen, der über ein Steuerventil 22 an den Nutz-Heliumbehälter 3 angeschlossen ist. Sollte der Druck im System insgesamt zu niedrig werden, insbesondere im Nutz-Heliumbehälter 3 oder im Reservoir-Heliumbehälter 8 unter den Umgebungsdruck (der bei ungefähr Atmosphärendruck= 1 bar liegt) fallen, so kann die Steuereinrichtung 17 mittels des Steuerventils 22 ein wenig Heliumgas in den Nutz-Heliumbehälter 3 einlassen. Mit dem zusätzlichen Heliumgas erhöht sich der Gasdruck im System.

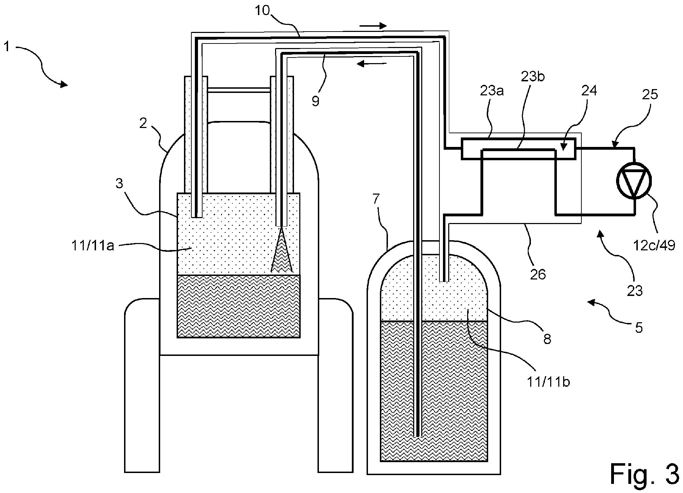

Eine dritte Ausführungsform einer Kryostaten-Anordnung 1 gemäß der Erfindung ist in **Fig. 3** dargestellt; diese dritte Ausführungsform ähnelt in weiten Teilen der Bauform von Fig. 1, so dass hier nur die wesentlichen Unterschiede erläutert werden. Zur Vereinfachung wurden in der Darstellung der Fig. 3 die Steuereinrichtung und daran angeschlossene Komponenten weggelassen.

In dieser Ausführungsform ist die Fördereinrichtung 49 mit einer Zirkulationspumpe 12c in einer Leitungsschleife 23 der Rückführleitung 10 ausgebildet. Die Leitungsschleife 23 ist mit einem Wärmetauscher 24 versehen. In der gezeigten Bauform ist ein Eingangsbereich 23a der Leiterschleife 23 mit einem Außenrohr ausgebildet, und ein Ausgangsbereich 23b der Leitungsschleife 23 mit einem Innenrohr, welches in dem Außenrohr verläuft ("Rohr in Rohr"). Das aus dem Nutz-Heliumbehälter 3 zufließende, zunächst kalte, gasförmige Helium 11/11b durchströmt das Außenrohr und fließt dann in einen raumtemperaturwarmen Schleifenteil 25 ein, wo es sich erwärmt. Im raumtemperaturwarmen Schleifenteil 25 pumpt die Zirkulationspumpe 12c das gasförmige Helium bei Raumtemperatur (ca. 20°C). Das dann raumtemperaturwarme, gasförmige Helium fließt dann von der Zirkulationspumpe 12c zum Innenrohr, und wird dort von dem umgebendem, kalten gasförmigen Helium im Außenrohr abgekühlt. Das solchermaßen mit dem Wärmetauscher 24 wieder gekühlte, gasförmige Helium fließt dann in den Reservoir-Heliumbehälter 8 ein.

Man beachte, dass der Wärmetauscher 24 einschließlich des Außenrohrs und des Innenrohrs vakuumisoliert ist, vgl. die Vakuumbegrenzung 26.

*Gemeinsame Transportleitung*

NMR-Magnete haben üblicherweise zwei oder drei Türme, die zum Heliumbehälter führen. In den bisher gezeigten Ausführungsformen wird das Helium in einem Magnetturm abgesaugt und in einem anderen Magnetturm zugeführt; dies ist für Verlegung und Anschluss der Zuführleitung und Rückführleitung besonders einfach, besonders wenn der NMR-Magnet über drei Türme verfügt, was gelegentlich der Fall ist. Es ist alternativ auch möglich und vorteilhaft, die TransferVorrichtung so auszuführen, dass Helium im gleichen Turm abgesaugt und zugeführt wird. So kann sichergestellt werden, dass bei Zweiturmsystemen zumindest ein Turm frei bleibt, damit ein ausreichend großer Abströmquerschnitt zu Verfügung steht, falls der NMR-Magnet während des Heliumtransfers quenchen sollte.

Die beiden Leitungen (Gasabsaugung und Zuführung von flüssigem Helium) können koaxial angeordnet werden, zumindest aber in einem gemeinsamen Vakuumraum.

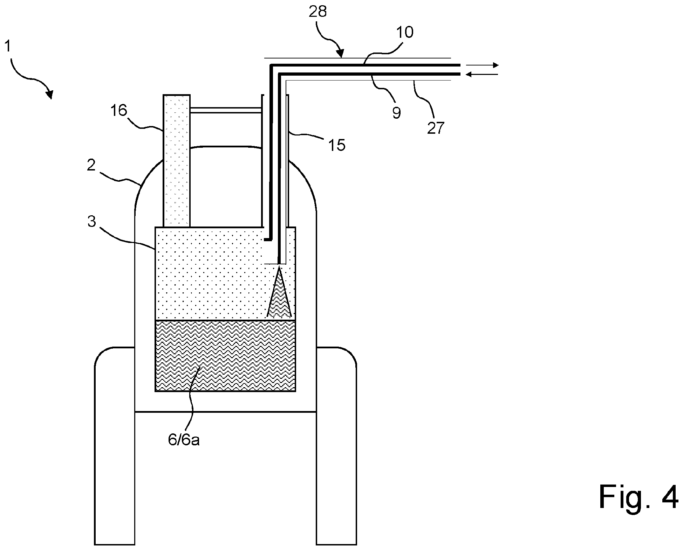

Die **Fig. 4** illustriert schematisch eine vierte Ausführungsform einer erfindungsgemäßen Kryobehälter-Anordnung 1 im Bereich des Nutz-Kryostaten 2. Es werden nur die wesentlichen Unterschiede zur Bauform von Fig. 1 erläutert.

In der gezeigten Ausführungsform verlaufen die Zuführleitung 9 und die Rückführleitung 10 in einer gemeinsamen Vakuumbegrenzung 27, wodurch eine gemeinsame Transportleitung 28 ausgebildet wird. Die gemeinsame Transportleitung 28 führt über einen einzigen Magnetturm (Heliumturm) 15 in den Nutz-Heliumbehälter 3. Der andere Magnetturm 16 wird für den Heliumtransfer nicht benötigt, und steht insbesondere mit seinem vollen Querschnitt für einen Ablass von Heliumgas im Falle eines Quenchs einer supraleitenden Magnetspule (nicht dargestellt), die mit dem flüssigen Helium 6/6a im Nutz-Heliumbehälter 3 gekühlt wird, zur Verfügung. Im Magnetturm 16 kann hierfür ein Überdruckventil oder eine Berstscheibe vorgesehen sein (nicht näher dargestellt).

Die Transferleitung (gemeinsame Transportleitung) wird üblicherweise nicht starr, sondern flexibel ausgeführt, um deren Handhabung (z.B. das Einstecken in den Transportdewar oder in den NMR-Magneten) einfacher zu gestalten. Anstatt starrer Rohre werden deshalb bevorzugt flexible Metallbälge verwendet. Die Leitungen, die Fluide führen, werden zur thermischen Isolation oft mit Superisolationsfolie (bzw. Band) umwickelt. Um zu verhindern, dass die fluidführenden Leitungen mit der warmen, das Vakuumisolationsvolumen abschließenden Begrenzungsleitung (auch genannt Vakuumbegrenzung) in direkte Berührung kommen können, was zu einem unzulässig hohen Wärmeeintrag führen würde, werden die fluidführenden Leitungen mittels Abstandhaltern von der Begrenzungsleitung beabstandet. Diese Abstandhalter (auch genannt Spacer) werden aus einem Material gefertigt, das nur eine kleine Wärmeleitfähigkeit hat, und deshalb thermisch isolierend wirkt (z.B. Nylon oder G10). Außerdem werden die Spacer geometrisch bevorzugt so geformt, dass die Brücken, über die Wärme fließt, so lang wie möglich sind, und so kleine Querschnitte wie möglich aufweisen. Außerdem können die beiden Leitungen koaxial ausgeführt werden, d.h. die Leitung für das gasförmige Helium (mit einem kreisringförmigen Querschnitt) umschließt die Leitung für das flüssige Helium, wobei die Leitungen voneinander durch Vakuum isoliert sind.

Um die Produktionskosten für die Transferleitung (gemeinsame Transportleitung) klein zu halten, ist es auch möglich, beide Leitungen mit kreisförmigen Querschnitt auszuführen. Hier ist es günstig, die Leitung für das flüssige Helium mechanisch über eine thermisch isolierende Struktur an der Leitung für das gasförmige Helium zu befestigen, um zu vermeiden, dass es einen direkten mechanischen Kontakt zwischen der warmen Vakuumbegrenzung und der kalten Leitung für flüssiges Helium gibt.

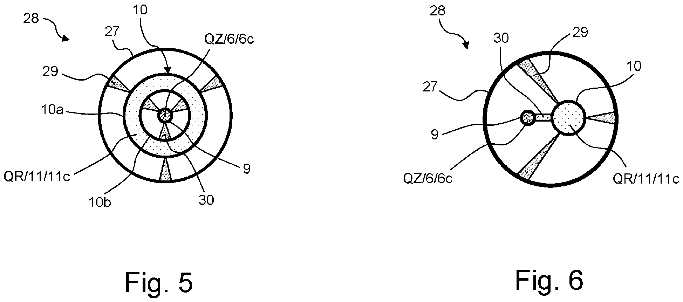

Die **Fig. 5** zeigt in einem schematischen Querschnitt eine beispielhafte, erste Bauform einer gemeinsamen Transportleitung 28 für die Erfindung. Die gemeinsame Transportleitung 28 ist hier im Querschnitt kreisrund ausgebildet. Sie verfügt radial außen über eine Vakuumbegrenzung 27, an der nach radial innen vorstehende mehrere Abstandhalter 29 angeordnet sind. An diesen ist radial innen die im Querschnitt kreisringförmige Rückführleitung 10 befestigt, in der gasförmiges Helium 11/11c geführt ist. Man beachte, dass die Rückführleitung 10 eine radial äußere Außenwand 10a und eine radial innere Innenwand 10b aufweist, die mittels Hilfs-Abstandhaltern (nicht näher dargestellt) gegeneinander abgestützt sind. An der Rückführleitung 10 nach radial innen abstehend sind weitere Abstandhalter 30 befestigt. An diesen ist radial innen die kreisförmige Zuführleitung 9 befestigt, die flüssiges Helium 6/6c führt. Im Raum zwischen der Vakuumbegrenzung 27 und der äußeren Wand 10a der Rückführleitung herrscht Vakuum, und im Raum zwischen der inneren Wand 10b der Rückführleitung 10 und der Zuführleitung 9 herrscht Vakuum. Ein Leitungsquerschnitt QR der Rückführleitung 10 ist hier etwa 12-Mal so groß wie ein Leitungsquerschnitt QZ der Zuführleitung 9.

In **Fig. 6** ist in einem schematischen Querschnitt eine beispielhafte zweiten Bauform einer gemeinsamen Transportleitung 28 gezeigt, die im Querschnitt ebenfalls kreisrund ausgebildet ist. An der Vakuumbegrenzung 27 sind wiederum Abstandhalter 29 angeordnet, die nach innen vorstehen. An deren inneren Enden ist die kreisförmige Rückführleitung 10 befestigt, die gasförmiges Helium 11/11c führt. Lateral an der Rückführleitung 10 ist ein von der Rückführleitung 10 abstehender, weiterer Abstandhalter 30 befestigt. An dessen der Rückführleitung 10 abgewandter Seite ist die kreisförmige Zuführleitung 9 befestigt, die das flüssige Helium 6/6c führt. Die Zuführleitung 9 und die Rückführleitung 10 sind von der Vakuumbegrenzung 27 beabstandet. Im Raum zwischen der Vakuumbegrenzung 27 und den Leitungen 9, 10 herrscht Vakuum. Ein Leitungsquerschnitt QR der Rückführleitung 10 ist hier etwa 6-Mal so groß wie ein Leitungsquerschnitt QZ der Zuführleitung 9.

In beiden Bauformen von Fig. 5 und Fig. 6 ist jeweils die Zuführleitung 9 lediglich über die Rückführleitung 10 mit der Vakuumbegrenzung 27 mechanisch verbunden.

*Berechnungsbeispiel und Integration in einem Laborverflüssiger*

In typischen Transfer-Vorrichtungen hat die Leitung für das flüssige Helium eine Länge von mehreren Metern und einen Durchmesser von etwa 4 mm. Bei einer Flussrate von 12,5 kg/h beträgt die Strömungsgeschwindigkeit in dieser Leitung etwa 2,2 m/s und die Strömung ist turbulent (Reynoldszahl ca. 350000). Der Druckverlust kann für den Fall, dass die Oberflächen der Leitung als technisch glatt angenommen werden können, berechnet werden und beträgt etwa 10 mbar pro Meter Leitungslänge. Dies entspricht gut der praktischen Beobachtung, dass bei Leitungen mit mehreren Metern Länge typischerweise ein Überdruck von ca. 50 mbar aufgebracht werden muss, um flüssiges Helium zu transferieren.

In der hier beschriebenen Transfer-Vorrichtung sollte die Leitung für das gasförmige Helium (Rückführleitung) so ausgeführt sein, dass der Druckverlust nicht unzulässig hoch wird. Es ist zu beachten, dass der Massenfluss durch die Leitung für das gasförmige Helium (Rückführleitung) deutlich kleiner ist als der Massenfluss durch die Leitung für das flüssige Helium (Zuführleitung). Konkret beträgt der Massenfluss durch die Leitung für das gasförmige Helium in erster Näherung (nämlich unter der Annahme, dass das gasförmige Helium eine Temperatur von 4,2 K hat) nur 13,2 Prozent des Massenflusses durch die Leitung für das flüssige Helium. In erster Näherung ist der Volumenstrom durch die beiden Leitungen gleich. Bei gleichem Querschnitt ist die Strömungsgeschwindigkeit deshalb gleich, und da die Dichte des gasförmigen Heliums kleiner ist als die des flüssigen Heliums, ergibt sich auch eine kleinere Reynoldszahl (118000) und ein kleinerer Druckverlust in der Größenordnung von 1,7 mbar pro Meter (für einen Durchmesser von 4 mm). Der Druckverlust in der Leitung für das gasförmige Helium ist also vernachlässigbar.

In der Praxis kommt es durch Imperfektionen in der Isolation der Transferleitung, durch die Pumpe, durch Reibung, durch die begrenzte Effizienz des Wärmetauschers, etc. zu Wärmeeinträgen in den Heliumkreislauf, die dazu führen, dass sich das gasförmige Helium am Weg vom NMR-Magneten zum Transportdewar leicht erwärmt. Eine Beispielrechnung zeigt, dass es gilt, diese Wärmeeinträge klein zu halten:
Es wird angenommen, dass kaltes, gasförmiges Helium mit einer Rate von 1,6 kg/h vom NMR-Magneten zum Transportdewar strömt. Es sei erwähnt, dass dieser Wert am unteren Ende der typischen Spanne liegt, d.h. es handelt sich hier um eine "Best-Case" Rechnung für einen verhältnismäßig langsamen Heliumtransfer. Unter der Annahme, dass sich die 1,6 kg gasförmigen Heliums am Weg vom Magneten zum Transportdewar von 4,2 K auf 10 K erwärmen, wäre eine "Kälteenergie" von 55,68 kJ bzw. eine Kühlleistung von 15 W nötig (über die Zeit von einer Stunde, die der Transfer dauert), um das Heliumgas wieder auf 4,2 K abzukühlen (die Enthalpie von Heliumgas bei 1 bar und 4,2 K beträgt 20,6 kJ/kg; die Enthalpie von Helium bei 1 bar und 10 K beträgt 55,4 kJ/kg). Dies ist um etwa eine Größenordnung mehr, als z.B. ein typischer Kryokühler in diesem Temperaturbereich leisten könnte.

Wenn sich die Temperatur des gasförmigen kalten Heliums, das vom NMR-Magneten zurück in den Transportdewar strömt, erhöht, steigt auch das spezifische Volumen des Gases, und der Druckverlust in der Leitung steigt an. Heliumgas bei 1 bar und einer Temperatur von 10 K erfährt in einer Leitung mit einem Durchmesser von 4 mm beispielsweise einen Druckverlust von 6,6 mbar - dies ist deutlich höher als die 1,7 mbar, die für eine Gastemperatur von 4,2 K berechnet wurden. Es ist deshalb vorteilhaft, den Querschnitt der Leitung für das rückströmende Gas mit etwas Reserve größer auszuführen, damit die Transfervorrichtung auch bei höheren Gastemperaturen zuverlässig funktioniert.

Die hier beschriebene Vorrichtung für Heliumtransfers kann auch in einen "Lab-Scale" Heliumverflüssiger (hier auch genannt Laborverflüssiger) integriert werden. In solchen Heliumverflüssigern werden Kryokühler - meist Pulsrohr- oder Gifford-McMahon Kühler - eingesetzt, um gasförmiges Helium mit einer vergleichsweise niederen Rate von etwa 20 l/d zu verflüssigen. Die Verflüssiger haben üblicherweise ein integriertes Speichervolumen (Volumen des Heliumbehälters im Kryostaten des Laborverflüssigers) von wenigen hundert Litern und sind auf Rollen montiert. Sobald Helium in einen NMR-Magneten transferiert werden soll, wird der gesamte Verflüssiger in die Nähe des Magneten bewegt, und der Transfer in den Magneten findet direkt aus dem in den Verflüssiger integrierten Speichervolumen statt.

Wird die hier beschriebene Transfer-Vorrichtung mit einem solchen "Lab-Scale" Verflüssiger oder "Laborverflüssiger" kombiniert, bietet es sich an, den Kryokühler zu nutzen, um das flüssige Helium vorab im integrierten Speichervolumen auf eine Temperatur unterhalb von 4,2 K abzukühlen. Wir das flüssige Helium beispielsweise auf 2,8 K abgekühlt, ist im Heliumbad "Kälteenergie" von 4,63 kJ/kg gespeichert (die Enthalpie von flüssigem Helium bei 1 bar und 4,2 K beträgt -0,12 kJ/kg, und die Enthalpie von flüssigem Helium bei 1 bar und 2,8 K beträgt -4,75 kJ/kg). Stehen im Verflüssiger zu Beginn des Transfers 100 Liter flüssiges Helium (also 12,5 kg) für den Transfer bereit (bei 2,8 K), sind also 57,8 kJ an Kühlenergie verfügbar. Dies ist mehr als benötigt würde, um 1,6 kg Heliumgas (das ist die Menge an Gas, die bei einem Transfer von 100 Litern flüssigen Heliums anfällt) von den oben angenommenen 10 K wieder auf 4,2 K abzukühlen. Die Abkühlung des im Speichervolumen befindlichen Heliums kann über Stunden und Tage vor dem geplanten Heliumtransfer erfolgen, und der im Verflüssiger eingesetzte Kryokühler muss für das vorgeschlagene Verfahren nicht übermäßig überdimensioniert werden.

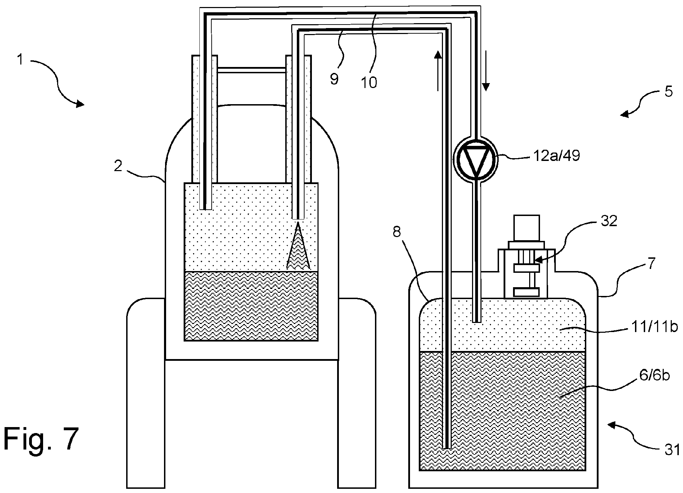

Eine fünfte Ausführungsform einer Kryostaten-Anordnung 1 gemäß der Erfindung ist in **Fig. 7** dargestellt; diese fünfte Ausführungsform ähnelt in weiten Teilen der Bauform von Fig. 1, so dass hier nur die wesentlichen Unterschiede erläutert werden. Zur Vereinfachung wurden in der Darstellung der Fig. 7 die Steuereinrichtung und daran angeschlossene Komponenten weggelassen.

In die Vorrichtung 5 zum Transfer von flüssigem Helium 6 ist bei dieser Ausführungsform ein Laborverflüssiger 31 integriert. Der Laborverflüssiger 31 umfasst den Reservoir-Kryostaten 7 mit dem Reservoir-Heliumbehälter 8 enthaltend flüssiges Helium 6/6b sowie einen Kryokühler 32. Mit dem Kryokühler 32 kann gasförmiges Helium 11/11b verflüssigt werden. Die kälteste Kühlstufe des Kryokühlers 32 ist dabei in der Lage, eine Temperatur deutlich unterhalb von 4,2 K zu erreichen. Dadurch ist es möglich, das flüssige Helium 6/6b im Reservoir-Heliumbehälter 8 auf eine Temperatur TLHe deutlich unterhalb von 4,2 K abzukühlen, beispielsweise auf hier ca. TLHe=2,8 K. Der Reservoir-Heliumbehälter 8 im Reservoir-Kryostaten 7 hat ein Speichervolumen von typischerweise 100-400 Litern.

Wird das flüssige Helium 6/6b im Reservoir-Heliumbehälter 8 unter die Temperatur des Phasenübergangs zum superfluiden Helium abgekühlt (2,17 K bei Atmosphärendruck), steht durch die hohe spezifische Wärme im Bereich des Phasenübergangs ein besonders großer Kältevorrat zu Verfügung.

*Ausführungsformen mit verschiebbarem Kolben*

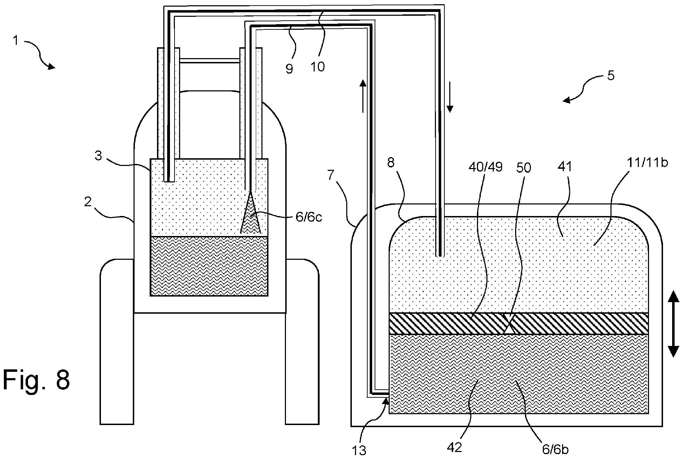

In den Figuren 8, 9 und 10 werden weitere Ausführungsformen von erfindungsgemäßen Kryostaten-Anordnungen 1 in schematischen Darstellungen vorgestellt, bei denen die Fördereinrichtung mit einem beweglichen Kolben im ReservoirKryostaten 7 ausgebildet ist. Die Ausführungsformen entsprechen weitgehend der Ausführungsform von Fig. 1, so dass nur die wesentlichen Unterschiede erläutert werden. Zur Vereinfachung wurden in der Darstellung der Figuren 8 bis 10 die Steuereinrichtung und daran angeschlossene Komponenten weggelassen.

In der sechsten Ausführungsform von **Fig. 8** ist im starr ausgebildeten, vakuumisolierten Reservoir-Heliumbehälter 8 ein hier horizontal ausgerichteter Kolben 40 einer Fördereinrichtung 49 angeordnet, der über einen nicht näher dargestellten, motorisierten Mechanismus im Reservoir-Heliumbehälter 8 verfahrbar ist, hier in vertikaler Richtung. Der Reservoir-Heliumbehälter 8 wird durch den Kolben 40 in einen oberen, ersten Teil 41 für gasförmiges Helium 11/11b und in einen unteren, zweiten Teil 42 für flüssiges Helium 6/6b unterteilt. Der Kolben 40, der an der Innenwand des Reservoir-Heliumbehälters 8 anliegt und an der Innenwand gleiten kann, trennt die beiden Teile 41, 42 gasdicht und flüssigkeitsdicht voneinander ab. Das Reservoirkryostaten-seitige Ende 13 der Zuleitung 9 geht vom zweiten Teil 42 ab. Die Rückführleitung 10 mündet in den ersten Teil 41.

Durch Verfahren des Kolbens 40 nach unten wird der zweite Teil 42 verkleinert und flüssiges Helium 6/6b in die Zuleitung 9 gedrückt, und dadurch flüssiges Helium 6/6c in den Nutz-Heliumbehälter 3 im Nutz-Kryostaten 2 gefördert. Gleichzeitig wird der erste Teil 41 vergrößert und aus der Rückführleitung 10 Heliumgas 11 in den Reservoir-Heliumbehälter 8 eingezogen, und dadurch aus dem Nutz-Heliumbehälter 3 in den Reservoir-Heliumbehälter 8 gefördert.

Bevorzugt ist der Kolben 40 thermisch isolierend ausgebildet, insbesondere vakuumisoliert ausgebildet. Dafür kann der Kolben 40 ganz oder teilweise aus einem Material niedriger thermischer Leitfähigkeit bestehen, beispielsweise einem Kunststoff, bevorzugt einem geschäumten Kunststoff. Der Kolben 40 kann auch zwei einander gegenüberliegende Platten umfassen, zwischen denen ein Vakuumraum ausgebildet ist (nicht näher dargestellt).

Man beachte, dass für die Funktion der Fördereinrichtung 49 bzw. des Kolbens 40 es unschädlich ist, wenn im ersten Teil 41 auch etwas flüssiges Helium vorhanden ist, und/oder im zweiten Teil auch etwas gasförmiges Helium vorhanden ist (gilt für alle Ausführungsformen der Figuren 8, 9 und 10). Falls gewünscht, kann im Kolben 40 ein über die Steuereinrichtung schaltbares Ventil 50 angeordnet sein, mit dem ein Durchlass im Kolben 40 zeitweilig geöffnet werden kann. Zum Fördern des flüssigen Heliums 6/6b (wie oben beschrieben) ist das schaltbare Ventil 50 geschlossen, also der Kolben 40 "dicht". Falls sich im unteren, zweiten Teil 42 eine störende Menge gasförmigen Heliums und/oder im oberen, ersten Teil 41 eine störende Menge flüssigen Heliums gebildet haben sollte (etwa aufgrund merklicher Wärmeleitung durch den Kolben 40 hindurch), kann in einer Förderpause das schaltbare Ventil 50 geöffnet werden. Flüssiges Helium aus dem oberen, ersten Teil 41 kann dann in den unteren, zweiten Teil 42 abfließen, und durch Absenken des Kolbens 40 kann der Raumanteil im unteren, zweiten Teil 42, der mit gasförmigem Helium gefüllt ist, minimiert werden; danach wird das schaltbare Ventil 50 wieder geschlossen, und der Förderbetrieb wird fortgesetzt. Ebenso kann das schaltbare Ventil 50 während einer ursprünglichen Befüllung des Reservoir-Kryostaten 7 mit flüssigem Helium 6/6b (etwa an einer Heliumförderstätte) geöffnet sein, um eine Befüllung "von oben" zu ermöglichen.

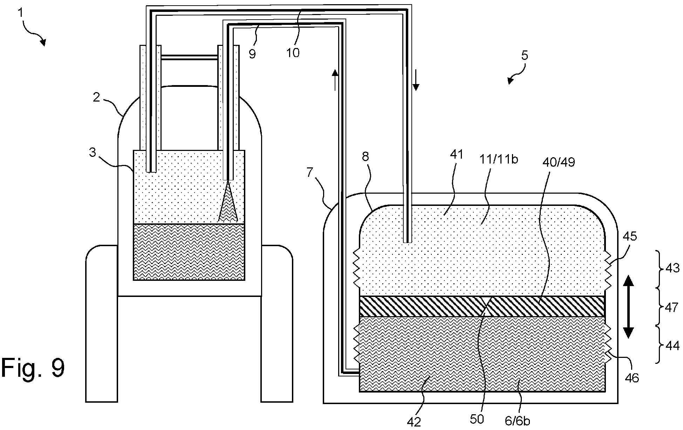

In der siebten Ausführungsform von **Fig. 9,** die weitgehend der Ausführungsform von Fig. 8 entspricht, so dass nur die wesentlichen Unterschiede hierzu erläutert werden, ist eine Wand des vakuumisolierten Reservoir-Heliumbehälters 8 in einem oberen Teilabschnitt 43 und in einem unteren Teilabschnitt 44 jeweils durch einen flexiblen Balg 45, 46 ausgebildet. In einem mittleren Teilabschnitt 47 sowie im Übrigen ist die Wand des Reservoir-Heliumbehälters 8 starr ausgebildet. An dem mittleren Teilabschnitt 47 ist der Kolben 40 der Fördereinrichtung 49 starr sowie gasdicht und flüssigkeitsdicht befestigt. Zudem sind die Bälge 45, 46 gasdicht und flüssigkeitsdicht. Der Reservoir-Heliumbehälter 8 wird dadurch in einen oberen, ersten Teil 41 für gasförmiges Helium 11/11b und in einen unteren, zweiten Teil 42 für flüssiges Helium 6/6b unterteilt. Der hier horizontal ausgerichtete Kolben 40 ist wiederum über einen nicht näher dargestellten, motorisierten Mechanismus im Reservoir-Heliumbehälter 8 verfahrbar, hier in vertikaler Richtung, so dass durch Absenken des Kolbens 40 flüssiges Helium 6/6b aus dem Reservoir-Heliumbehälter 8 in die Zuführleitung 9 ausgefördert und gasförmiges Helium 11 aus der Rückführleitung 10 in den Reservoir-Heliumbehälter 8 eingesaugt werden kann.

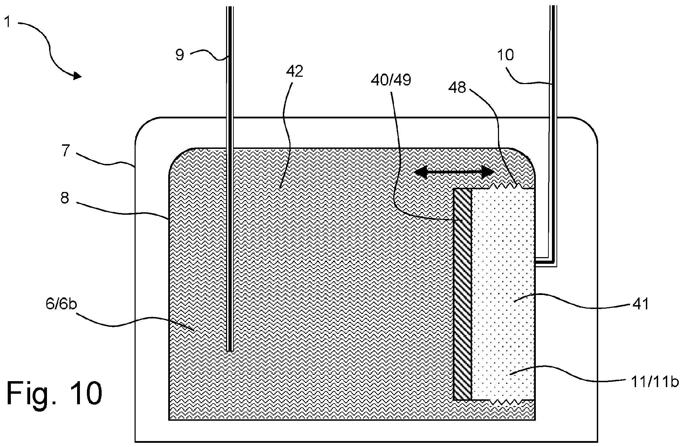

Die **Fig. 10** zeigt zur Vereinfachung lediglich eines Ausschnitt aus einer achten Ausführungsform der Kryostaten-Anordnung 1 im Bereich des ReservoirKryostaten 7. Der nach außen hin vakuumisolierte Reservoir-Heliumbehälter 8 ist hier wiederum starr ausgebildet. Im Innenraum des Reservoir-Heliumbehälters 8 ist mit dem hier vertikal ausgerichteten Kolben 40 und einem flexiblen Balg 48, der an der Innenseite einer vertikalen Seitenwand des Reservoir-Heliumbehälters 8 befestigt ist, ein erster Teil 41 für gasförmiges Helium 11/11b gasdicht und flüssigkeitsdicht abgetrennt, der übrige Innenraum des Reservoir-Heliumbehälters 8 bildet den zweiten Teil 42 für flüssiges Helium 6/6b aus. Mit einem nicht näher dargestellten motorischen Mechanismus kann der Kolben 40 hier horizontal verfahren werden. Wenn der Kolben 42 in Fig. 10 nach links verfahren wird, also der zweite Teil 42 verkleinert und der erste Teil 41 vergrößert wird, wird flüssiges Helium 6/6b aus dem zweiten Teil in die Zuführleitung 9 ausgefördert, und gasförmiges Helium 11 an der Rückführleitung 10 in den ersten Teil 41 angesaugt.

Für eine bessere thermische Isolierung zwischen dem ersten Teil 41 und dem zweiten Teil 42 kann der Balg 48 auch thermisch isolierend ausgebildet sein, etwa mit einer doppelten Wandung und dazwischenliegendem Vakuumraum (nicht näher dargestellt).

Bezugszeichenliste

| 1 | Kryostaten-Anordnung |
| 2 | Nutz-Kryostat |
| 3 | Nutz-Heliumbehälter |
| 5 | Vorrichtung zum Transfer von flüssigem Helium |
| 6 | flüssiges Helium (allgemein) |
| 6a | flüssiges Helium (im Nutz-Heliumbehälter |
| 6b | flüssiges Helium (im Reservoir-Heliumbehälter) |
| 6c | flüssiges Helium (gefördert durch Zuführleitung) |
| 7 | Reservoir-Kryostat (Transportdewar) |
| 8 | Reservoir-Heliumbehälter |
| 9 | Zuführleitung |
| 10 | Rückführleitung |
| 10a | Außenwand der Rückführleitung |
| 10b | Innenwand der Rückführleitung |
| 11 | gasförmiges Helium (allgemein) |
| 11a | gasförmiges Helium (im Nutz-Heliumbehälter) |
| 11b | gasförmiges Helium (im Reservoir-Heliumbehälter) |
| 11c | gasförmiges Helium (gefördert durch die Rückführleitung) |
| 12a | Zirkulationspumpe (in Rückführleitung, kalt) |
| 12b | Zirkulationspumpe (in Zuführleitung) |
| 12c | Zirkulationspumpe (in Rückführleitung, in Leitungsschleife) |
| 13 | Reservoirkryostaten-seitiges Ende der Zuführleitung |
| 14 | Nutzkryostaten-seitiges Ende der Zuführleitung |
| 15 | Heliumturm (Magnetturm) |
| 16 | Heliumturm (Magnetturm) |
| 17 | Steuereinrichtung |
| 18 | Drucksensor (im Reservoir-Heliumbehälter) |
| 19 | Drucksensor (im Nutz-Heliumbehälter) |
| 20 | Heizeinrichtung |
| 21 | Helium-Druckgasspeicher |
| 22 | Steuerventil |
| 23 | Leitungsschleife |
| 23a | Eingangsbereich der leitungsschleife |
| 23b | Ausgangsbereich der Leitungsschleife |
| 24 | Wärmetauscher |
| 25 | raumtemperaturwarmer Schleifenteil |
| 26 | Vakuumbegrenzung |
| 27 | Vakuumbegrenzung (gemeinsame Transportleitung) |
| 28 | gemeinsame Transportleitung |
| 29 | Abstandhalter (Vakuumbegrenzung zu Rückführleitung) |
| 30 | Abstandhalter (Rückführleitung zu Zuführleitung) |
| 31 | Laborverflüssiger |
| 32 | Kryokühler |
| 40 | Kolben |
| 41 | erster Teil |
| 42 | zweiter Teil |
| 43 | oberer Teilabschnitt |
| 44 | unterer Teilabschnitt |

| | |
|---|---|
| 45 | oberer Balg |
| 46 | unterer Balg |
| 47 | mittlerer Teilabschnitt |
| 48 | Balg |
| 49 | Fördereinrichtung |
| 50 | schaltbares Ventil (im Kolben) |
| QR | Leitungsquerschnitt der Rückführleitung |
| QZ | Leitungsquerschnitt der Zuführleitung |

**Patentansprüche**

1. Vorrichtung (5) zum Transfer von flüssigem Helium (6) in einen Nutz-Heliumbehälter (3) eines Nutz-Kryostaten (2), wobei die Vorrichtung (5) umfasst:

   - einen Reservoir-Kryostaten (7) mit einem vakuumisolierten Reservoir-Heliumbehälter (8), zur Bevorratung von flüssigem Helium (6, 6b), das zum Befüllen des Nutz-Heliumbehälters (3) zur Verfügung steht,
   - eine Zuführleitung (9) für flüssiges Helium (6, 6c), die vom Reservoir-Heliumbehälter (8) abgeht, zum Anschluss an den Nutz-Heliumbehälter (3);

   **dadurch gekennzeichnet,**
   **dass** die Vorrichtung (5) weiterhin umfasst:

   - eine Rückführleitung (10) für gasförmiges Helium (11, 11c), die in den Reservoir-Heliumbehälter (8) führt, zum Anschluss an den Nutz-Heliumbehälter (3), und
   - eine Fördereinrichtung (49), mit der flüssiges Helium (6, 6b) aus dem Reservoir-Heliumbehälter (8) durch die Zuführleitung (9) in den Nutz-Heliumbehälter (3) und gasförmiges Helium (11, 11a) aus dem Nutz-Heliumbehälter (3) durch die Rückführleitung (10) in den Reservoir-Heliumbehälter (8) förderbar ist.

2. Vorrichtung (5) nach Anspruch 1, **dadurch gekennzeichnet, dass** die Zuführleitung (9) und die Rückführleitung (10) vakuumisoliert sind.

3. Vorrichtung (5) nach Anspruch 2, **dadurch gekennzeichnet, dass** die Zuführleitung (9) und die Rückführleitung (10) zumindest teilweise in einer gemeinsamen Transportleitung (28) ausgebildet sind, die innerhalb einer gemeinsamen Vakuumbegrenzung (27) einen Vakuumraum aufweist, in dem sowohl die Zuführleitung (9) als auch die Rückführleitung (10) verlaufen.

4. Vorrichtung (5) nach Anspruch 3, **dadurch gekennzeichnet,**
   **dass** die Zuführleitung (9) und die Rückführleitung (10) koaxial innerhalb der gemeinsamen Vakuumbegrenzung (27) verlaufen, wobei die Zuführleitung (9) radial innerhalb der Rückführleitung (10) liegt.

5. Vorrichtung (5) nach Anspruch 3, **dadurch gekennzeichnet,**
   **dass** die Zuführleitung (9) und die Rückführleitung (10) zueinander parallel und nebeneinander liegend in der gemeinsamen Vakuumbegrenzung (27) verlaufen.

6. Vorrichtung (5) nach einem der Ansprüche 3 bis 5, **dadurch gekennzeichnet, dass** die Rückführleitung (10) mittels einem oder mehreren Abstandhaltern (29) an der gemeinsamen Vakuumbegrenzung (27) aufgehängt ist, und dass die Zuführleitung (9) mit einem oder mehreren Abstandhaltern (30) an der Rückführleitung (10) aufgehängt ist, nicht aber an der gemeinsamen Vakuumbegrenzung (27).

7. Vorrichtung (5) nach einem der vorhergehenden Ansprüche, **dadurch gekennzeichnet, dass** für einen Leitungsquerschnitt QZ der Zuführleitung (9) und einen Leitungsquerschnitt QR der Rückführleitung (10) gilt:

$$QR > QZ,$$

   bevorzugt $QR \geq 3*QZ$,
   besonders bevorzugt $QR \geq 5*QZ$.

8. Vorrichtung (5) nach einem der vorhergehenden Ansprüche, **dadurch gekennzeichnet, dass** die Zuführleitung (9) und die Rückführleitung (10) flexibel ausgebildet sind.

9. Vorrichtung (5) nach einem der Ansprüche 1 bis 8, **dadurch gekennzeichnet, dass** die Fördereinrichtung (49) eine Zirkulationspumpe (12b) für flüssiges Helium (6; 6c) in der Zuführleitung (9) umfasst.

10. Vorrichtung (5) nach einem der Ansprüche 1 bis 8, **dadurch gekennzeichnet, dass** die Fördereinrichtung (49) eine Zirkulationspumpe (12a; 12c) für gasförmiges Helium (11, 11c) in der Rückführleitung (10) umfasst.

11. Vorrichtung (5) nach Anspruch 10, **dadurch gekennzeichnet,**

    **dass** die Rückführleitung (10) eine Leitungsschleife (23) mit einem Eingangsbereich (23a) und einem Ausgangsbereich (23b) umfasst, wobei der Ausgangsbereich (23b) über einen Wärmetauscher (24) mit dem Eingangsbereich (23a) thermisch gekoppelt ist, und **dass** die Leitungsschleife (23) die Zirkulationspumpe (12c) enthält, insbesondere wobei die Zirkulationspumpe (12c) auf Raumtemperatur ist.

12. Vorrichtung (5) nach einem der Ansprüche 1 bis 8, **dadurch gekennzeichnet,**

dass die Fördereinrichtung (49) einen Kolben (40) im Reservoir-Heliumbehälter (8) umfasst, wobei der Kolben (40) im Reservoir-Heliumbehälter (8) verfahrbar ist und einen ersten Teil (41) des Reservoir-Heliumbehälters (8) für gasförmiges Helium (11, 11b) von einem zweiten Teil (42) des Reservoir-Heliumbehälters (8) für flüssiges Helium (6, 6b) trennt, und dass die Zuführleitung (9) im zweiten Teil (42) abgeht, und die Rückführleitung (10) in den ersten Teil (41) führt.

13. Vorrichtung (5) nach einem der vorhergehenden Ansprüche, **dadurch gekennzeichnet, dass** die Vorrichtung (5) weiterhin eine Steuereinrichtung (17) zur Regelung eines Heliumdrucks in der Vorrichtung (5) und/oder in dem Nutz-Heliumbehälter (3) umfasst, insbesondere wobei die Steuereinrichtung (17) dazu ausgebildet ist, die Fördereinrichtung (49) anzusteuern.

14. Vorrichtung (5) nach Anspruch 13, **dadurch gekennzeichnet, dass** die Vorrichtung (5) weiterhin umfasst:

- eine Heizeinrichtung (20), insbesondere angeordnet im Reservoir-Heliumbehälter (8); und/oder
- einen Helium-Druckgasspeicher (21) mit einem Steuerventil (22), insbesondere zum Anschluss an den Nutz-Heliumbehälter (3),

insbesondere wobei die Steuereinrichtung (17) dazu ausgebildet ist, die Heizeinrichtung (20) und/oder das Steuerventil (22) anzusteuern.

15. Vorrichtung (5) nach einem der vorhergehenden Ansprüche, **dadurch gekennzeichnet,** dass die Vorrichtung (5) einen Laborverflüssiger (31) für Helium umfasst, wobei der Laborverflüssiger (31) umfasst:

- den Reservoir-Kryostaten (7) mit dem Reservoir-Heliumbehälter (8), und
- einen Kryokühler (32) zur Verflüssigung von gasförmigem Helium (11).

16. Kryobehälter-Anordnung (1),

umfassend eine Vorrichtung (5) nach einem der vorhergehenden Ansprüche sowie den Nutz-Kryostaten (2) mit dem Nutz-Heliumbehälter (3),

wobei die Zuführleitung (9) an den Nutz-Heliumbehälter (3) angeschlossen ist und in den Nutz-Heliumbehälter (3) führt, und wobei die Rückführleitung (10) an den Nutz-Heliumbehälter (3) angeschlossen ist und von dem Nutz-Heliumbehälter (3) abgeht.

17. Kryobehälter-Anordnung (1) nach Anspruch 16, **dadurch gekennzeichnet, dass** die Kryobehälter-Anordnung (1) weiterhin wenigstens einen Drucksensor (19) im Bereich des Nutz-Heliumbehälters (3) umfasst, insbesondere wobei der Drucksensor (19) an eine Steuereinrichtung (17) der Vorrichtung (5) angeschlossen ist.

18. Verfahren zum Transfer von flüssigem Helium aus einem Reservoir-Heliumbehälter (8) eines Reservoir-Kryostaten (7) in einen Nutz-Heliumbehälter (3) eines Nutz-Kryostaten (2),

wobei durch eine Zuführleitung (9) für flüssiges Helium (6, 6c), die vom Reservoir-Heliumbehälter (8) abgeht und an den Nutz-Heliumbehälter (3) angeschlossen ist, in dem Reservoir-Heliumbehälter (8) bevorratetes flüssiges Helium (6, 6b) aus dem Reservoir-Heliumbehälter (8) in den Nutz-Heliumbehälter (3) gefördert wird, **dadurch gekennzeichnet, dass** gleichzeitig durch eine Rückführleitung (10) für gasförmiges Helium (11, 11c), die an den Nutz-Heliumbehälter (3) angeschlossen ist und in den Reservoir-Heliumbehälter (8) führt, gasförmiges Helium (11, 11a) aus dem Nutz-Heliumbehälter (3) in den Reservoir-Heliumbehälter (8) zurückgeführt wird.

19. Verfahren nach Anspruch 18, **dadurch gekennzeichnet, dass** die Volumenströme von flüssigem Helium (6, 6c) durch die Zuführleitung (9) und von gasförmigem Helium (11, 11c) durch die Rückführleitung (10) näherungsweise gleich sind.

20. Verfahren nach Anspruch 18 oder 19, **dadurch gekennzeichnet, dass** für eine Temperatur TLHe des flüssigen Heliums (6, 6b) im Reservoir-Heliumbehälter (8) zumindest zu Beginn des Transfers des flüssigen Heliums (6, 6b) gilt:

$$TLHe < 4{,}2\ K,$$

bevorzugt TLHe $\leq$ 3,6 K, besonders bevorzugt TLHe $\leq$ 3,0 K, insbesondere wobei die die Temperatur TLHe des flüssigen Heliums (6, 6b) im Reservoir-Heliumbehälter (8) vor Beginn des Transfers des flüssigen Heliums (6, 6b) mit einem Kryokühler (32) eines Laborverflüssigers (31) eingestellt wurde, in welchen der Reservoir-Kryostat (7) mit dem Reservoir-Heliumbehälter (8) integriert ist.

Fig. 1

Fig. 2

Fig. 3

Fig. 4

Fig. 5

Fig. 6

Fig. 7

Fig. 8

Fig. 9

1

9

7

8

6/6b

42

40/49

48

10

41

11/11b

Fig. 10

Europäisches
Patentamt

European
Patent Office

Office européen
des brevets

# EUROPÄISCHER RECHERCHENBERICHT

**Nummer der Anmeldung**

**EP 23 19 4761**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JP S59 129354 A (HITACHI LTD) 25. Juli 1984 (1984-07-25) <br><br> * Absätze [0001] – [0003]; Abbildung 2 * <br> ----- | 1-8, 10-12, 15-20 | INV. <br> F17C3/08 |
| X | JP 2015 056536 A (FUJI ELECTRIC CO LTD) 23. März 2015 (2015-03-23) <br> * Absätze [0004] – [0036]; Abbildungen 1-6 * <br><br> ----- | 1-9, 13-20 | |
| A | US 2005/217281 A1 (ADLER ROBERT [AT] ET AL) 6. Oktober 2005 (2005-10-06) <br> * Anspruch 1; Abbildung 1 * <br> ----- | 10,11 | |
| A | JP 4 886552 B2 (IHI CORP; TAIYO NIPPON SANSO CORP) 29. Februar 2012 (2012-02-29) <br> * Abbildung 1 * <br> ----- | 12 | |
| | | | **RECHERCHIERTE SACHGEBIETE (IPC)** <br><br> F17C |

Der vorliegende Recherchenbericht wurde für alle Patentansprüche erstellt

| Recherchenort | Abschlußdatum der Recherche | Prüfer |
|---|---|---|
| München | 8. Februar 2024 | Fritzen, Claas |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

.............................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 23 19 4761

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-02-2024

| Im Recherchenbericht angeführtes Patentdokument | Datum der Veröffentlichung | Mitglied(er) der Patentfamilie | Datum der Veröffentlichung |
|---|---|---|---|
| JP S59129354 A | 25-07-1984 | KEINE | |
| JP 2015056536 A | 23-03-2015 | KEINE | |
| US 2005217281 A1 | 06-10-2005 | CN 1654911 A | 17-08-2005 |
| | | DE 102004005305 A1 | 11-08-2005 |
| | | EP 1562013 A1 | 10-08-2005 |
| | | JP 2005221223 A | 18-08-2005 |
| | | US 2005217281 A1 | 06-10-2005 |
| JP 4886552 B2 | 29-02-2012 | JP 4886552 B2 | 29-02-2012 |
| | | JP 2008215640 A | 18-09-2008 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110312502 A
- US 20190211970 A1
- US 3399691 A
- JP S54161109 A
- FR 2752037 A1
- US 6442948 B1

**In der Beschreibung aufgeführte Nicht-Patentliteratur**

- Cryostat Design. International Cryogenics Monograph Series. Springer International Publishing, 2016
- **D. KRAMER.** Helium is again short in supply. *Physics Today,* 04. April 2022